# EUROPEAN PATENT APPLICATION

(11) **EP 2 736 160 A1**
(43) Date of publication of application: **28.05.2014**
(21) Application number: 12817746.6
(22) Date of filing: 09.07.2012
(51) Int. Cl.: H02M 7/48

(54) **POWER CONVERSION DEVICE**

(30) Priority: 22.07.2011 JP 2011161145
(71) Applicant: Hitachi Automotive Systems, Ltd., Hitachinaka-shi, Ibaraki 312-8503 (JP)
(72) Inventor: SHINOHARA, Shuichi, Hitachinaka-shi Ibaraki 312-8503 (JP); NAKAJIMA, Kenichiro, Hitachinaka-shi Ibaraki 312-8503 (JP); SASAKI, Kaname, Hitachinaka-shi Ibaraki 312-8503 (JP)
(74) Representative: MERH-IP Matias Erny Reichl Hoffmann
(86) International application number: PCT/JP2012/067515
(87) International publication number: WO 2013/015105

(57) **Abstract**

Provided is a power inverter including a plurality of power modules, a first casing in which the plurality of power modules are housed and a cooling path in which a coolant flows is formed, a plurality of AC busbars that are respectively connected to AC terminals of the plurality of power modules, a holding member, in which a positioning pin protruding to an upper side in a direction opposite to the first casing is formed, that maintains the plurality of AC busbars and is fixed to the first casing, a current sensor module that includes a plurality of current sensors detecting the AC currents of the plurality of AC busbars, a frame body, in which a module positioning through hole is formed, that integrally maintains the plurality of current sensors, and a lead terminal protruding from the frame body to the upper side, and a driver circuit board, in which a through hole used for the lead terminal and a board positioning through hole are formed, that is arranged on the upper side of the frame body arranged on the holding member. A tip end of the positioning pin protrudes to the upper side of a tip end of the lead terminal that protrudes from the frame body arranged in the holding member.

## Description

### Technical Field

The present invention relates to a power inverter that drives a rotating electrical machine.

### Background Art

In PTL 1, a power inverter that is mounted in a hybrid vehicle such as a hybrid electric vehicle and drives a rotating electrical machine is disclosed. The power inverter is equipped with a power module that includes a power semiconductor device for each one of three phases. An AC current supplied from each power module is configured to be output through a busbar. A current flowing through each busbar is detected by a current sensor such as a Hall sensor, and the sensor signal is output to a control circuit board, which controls the power semiconductor device, through a lead terminal disposed in the current sensor.

From the viewpoint of decreasing the whole size of the power inverter, it is preferable that a gap between the current sensor and the control circuit board be as small as possible. Accordingly, in the power inverter disclosed in PTL 1, a configuration is employed in which the lead terminal disposed in the current sensor is directly connected to a through hole of the control circuit board.

In PTL 1, sensor blocks each equipped with the current sensor device are divided for each phase, and the sensor blocks are fixed on the same heat sink. Then, the lead terminal protruding from each sensor block to the upper side is inserted into the through hole that is formed in the control circuit board. In each sensor block, a positioning pin that is inserted into and passed through the through hole formed in the control circuit board is disposed, and is used for positioning the board and the sensor block when the lead terminal is inserted into the through hole.

### Citation List

### Patent Literature

PTL 1: Japanese Patent Application Laid-Open No. 2006-81311

### Summary of Invention

### Technical Problem

However, each sensor block is individually positioned on the heat sink, and thus, when the positioning precision between the sensor blocks is not high, there is a problem in that sufficient positioning precision between each sensor block and the control circuit board is not acquired. In other words, a situation may easily occur in which, while the lead terminals of some sensor blocks can be inserted into through holes, the lead terminals of the other sensor blocks cannot be inserted into through holes. In such a case, it is necessary to fix each sensor block to the heat sink again, whereby the operability is low.

### Solution to Problem

According to a first aspect of the present invention, there is provided a power inverter including: a plurality of power modules each including a power semiconductor device that converts a DC current into an AC current; a first casing in which the plurality of power modules are housed, and a cooling path in which a coolant used for cooling the plurality of power modules flows is formed; a plurality of AC busbars that are respectively connected to AC terminals of the plurality of power modules and are used for outputting AC currents; a holding member, in which a positioning pin protruding to an upper side in a direction opposite to the first casing is formed, that maintains the plurality of AC busbars and is fixed to the first casing; a current sensor module that includes a plurality of current sensors detecting the AC currents of the plurality of AC busbars, a frame body, in which a module positioning through hole which the positioning pin is inserted into and is passed through is formed, that integrally maintains the plurality of current sensors and is arranged on the holding member, and a lead terminal being disposed to protrude from the frame body to the upper side and outputting detection signals of the plurality of current sensors; and a driver circuit board, in which a through hole used for the lead terminal which the lead terminal is inserted into and passed through and a board positioning through hole which the positioning pin is inserted into and passed through are formed, that is arranged on the upper side of the frame body arranged on the holding member and has a circuit, which drives the power semiconductor device based on the detection signals, being mounted. A tip end of the positioning pin protrudes to the upper side of a tip end of the lead terminal that protrudes from the frame body arranged in the holding member.

### Advantageous Effects of Invention

According to the present invention, operability of assembly of a power inverter can be improved.

### Brief Description of Drawings

[FIG. 1] FIG. 1 is a diagram illustrating a control block of a hybrid electric vehicle in a case where a power inverter according to an embodiment of the present invention is applied.
[FIG. 2] FIG. 2 is a diagram illustrating the configuration of an inverter circuit 140.
[FIG. 3] FIG. 3 is an external perspective view of a power inverter 200.
[FIG. 4] FIG. 4 is a diagram illustrating the power inverter 200 excluding an AC connector 187 and a DC connector 138.
[FIG. 5] FIG. 5 is a diagram illustrating the power inverter 200 excluding a DC interface 137 and an AC interface 185.
[FIG. 6] FIG. 6 is a diagram illustrating a state acquired by excluding a chassis 10 from a cooling block 12.
[FIG. 7] FIG. 7 is an exploded perspective view of the power inverter 200.
[FIG. 8] FIG. 8 is a perspective view of a lower casing that is configured by the cooling block 12 and a bottom cover 420.
[FIG. 9] FIG. 9 is an exploded perspective view of the lower casing seen from the rear face side.
[FIG. 10] FIG. 10 is a perspective view of a power module.
[FIG. 11] FIG. 11 is a cross-sectional view of a power module.
[FIG. 12] FIG. 12 is a perspective view of a module sealing body 302.
[FIG. 13] FIG. 13 is an external perspective view of a capacitor module 500.
[FIG. 14] FIG. 14 is a diagram illustrating the cooling block 12 in which power modules 300U to 300W and the capacitor module 500 are housed.
[FIG. 15] FIG. 15 is a traversal cross-sectional view of the cooling block 12.
[FIG. 16] FIG. 16 is a schematic diagram illustrating the arrangement of the power modules 300U to 300W.
[FIG. 17] FIG. 17 is a diagram in which a busbar assembly 800 is additionally arranged in the configuration illustrated in FIG. 14.
[FIG. 18] FIG. 18 is a perspective view of the busbar assembly 800.
[FIG. 19] FIG. 19 is a diagram illustrating the positioning of a driver circuit board 22 using a positioning pin 806a.
[FIG. 20] FIG. 20 is a diagram illustrating a connection portion of an AC busbar 802U and AC terminals 321 of the power modules 300U to 300W.
[FIG. 21] FIG. 21 is a diagram illustrating the operation of locking the AC busbar 802U by using a hook 803a.
[FIG. 22] FIG. 22 is a cross-sectional view of an area near an output end of the AC busbar 802U.
[FIG. 23] FIG. 23 is a diagram illustrating an insulating sheet 220 placed on the driver circuit board 22.
[FIG. 24] FIG. 24 is a cross-sectional view of the power inverter 200.
[FIG. 25] FIG. 25 is a cross-sectional view illustrating a fixing portion of a holding member 803.
[FIG. 26] FIG. 26 is a diagram illustrating another example of the fixing structure of the holding member 803.
[FIG. 27] FIG. 27 is a diagram illustrating a current sensor disposed inside a frame body 180b.

### Description of Embodiments

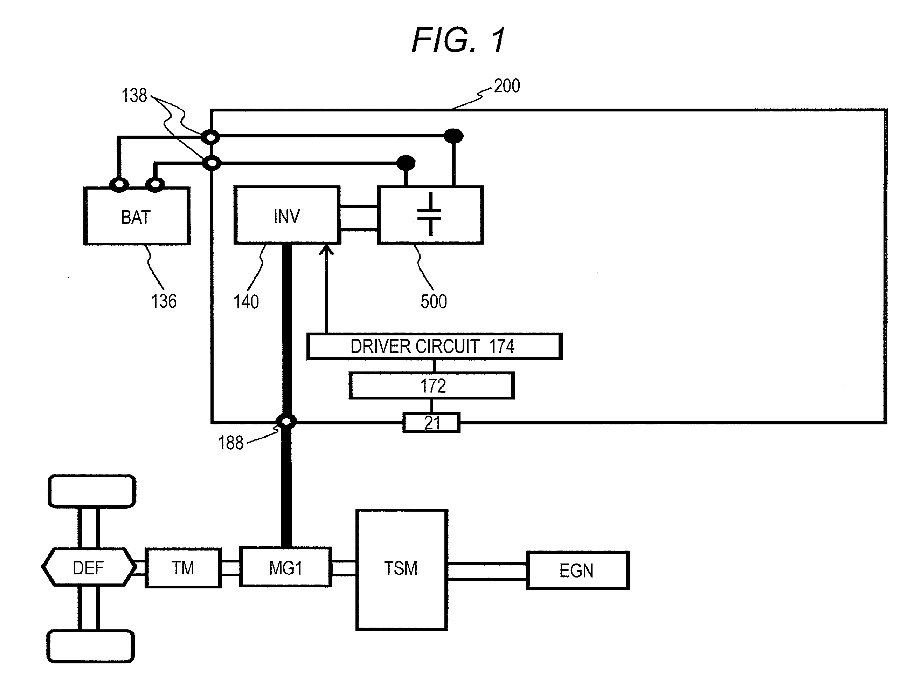

Hereinafter, embodiments of the present invention will be described with reference to the drawings. FIG. 1 is a diagram illustrating a control block of a hybrid electric vehicle (hereinafter, referred to as an "HEV"). An engine EGN and an electrical motor generator MG1 generate a driving torque of a vehicle. In addition, the electrical motor generator MG1 not only generates rotating torque but also has a function for converting mechanical energy applied to the electrical motor generator MG1 from the outside thereof into electric power.

The electrical motor generator MG1, for example, is a synchronous machine or an induction machine and, as described above, operates either as an electrical motor or as a generator in accordance with the operating method. In the case of mounting the electrical motor generator MG1 in a vehicle, it is preferable that the electrical motor generator MG1 be small and have a high output level, and a permanent magnet-type synchronous electrical motor using a magnet such as neodymium may be appropriately used. In addition, the permanent magnet-type synchronous electrical motor has a small amount of heat generation of a rotor than that of an induction electric motor, thus in this view point, is superior for being used in a vehicle.

The output torque of the output side of the engine EGN is transferred to the electrical motor generator MG1 through a power transfer TSM, and the rotating torque transferred from the power transfer TSM or the rotating torque generated by the electrical motor generator MG1 is transferred to a wheel through a transmission TM and a differential gear DEF. On the other hand, at the time of a regenerative braking operation, the rotating torque is transferred to the electrical motor generator MG1 from the wheel, and AC (alternate converter) power is generated based on the supplied rotating torque. The generated AC power, as will be described later, is converted into DC (direct converter) power by the power inverter 200 and charges a high-voltage battery 136, and the charged power is used as drive energy again.

Next, the power inverter 200 will be described. An inverter circuit 140 is electrically connected to the battery 136 through a DC connector 138, and power is transmitted and received between the battery 136 and the inverter circuit 140. In a case where the electrical motor generator MG1 operates as an electrical motor, the inverter circuit 140 generates AC power based on the DC power supplied from the battery 136 through the DC connector 138 and supplies the generated AC power to the electrical motor generator MG1 through an AC terminal 188. The configuration of the electrical motor generator MG1 and the inverter circuit 140 operates as a motor generator.

In addition, in this embodiment, by operating the motor generator as a motor unit using the power of the battery 136, the vehicle can be driven using only the power of the electrical motor generator MG1. In addition, in this embodiment, power is generated by operating the motor generator as a power generation unit using the power of the engine 120 or the power transferred from the wheel, and whereby the battery 136 can be charged.

Although not illustrated in FIG. 1, the battery 136 is used also as a power source that is used for driving an electrical motor used for an auxiliary component. The electrical motor used for the auxiliary component, for example, is an electric motor that drives a compressor of an air conditioner or an electrical motor that drives a control hydraulic pump. The DC power is supplied from the battery 136 to the power module used for the auxiliary component, and the power module used for the auxiliary component generates AC power and supplies the generated AC power to the electrical motor used for the auxiliary component. The power module used for the auxiliary component has a circuit configuration and a function that is basically the same as those of the inverter circuit 140 and controls the phase, the frequency, and electric power of the AC power supplied to the electrical motor used for the auxiliary component. In addition, the power inverter 200 is equipped with a capacitor module 500 used for smoothing the DC power supplied to the inverter circuit 140.

The power inverter 200 is equipped with a connector 21 for communication that is used for receiving an instruction from an upper-level control device or transmitting data representing the state to a higher-level control device. The power inverter 200 calculates the control amount of the electrical motor generator MG1 using a control circuit 172 based on an instruction input from the connector 21, further calculates whether the electrical motor generator is to be operated as an electrical motor or a generator, generates a control pulse based on a result of the calculation, and supplies the control pulse to a driver circuit 174. The driver circuit 174 generates a drive pulse used for controlling the inverter circuit 140 based on the supplied control pulse.

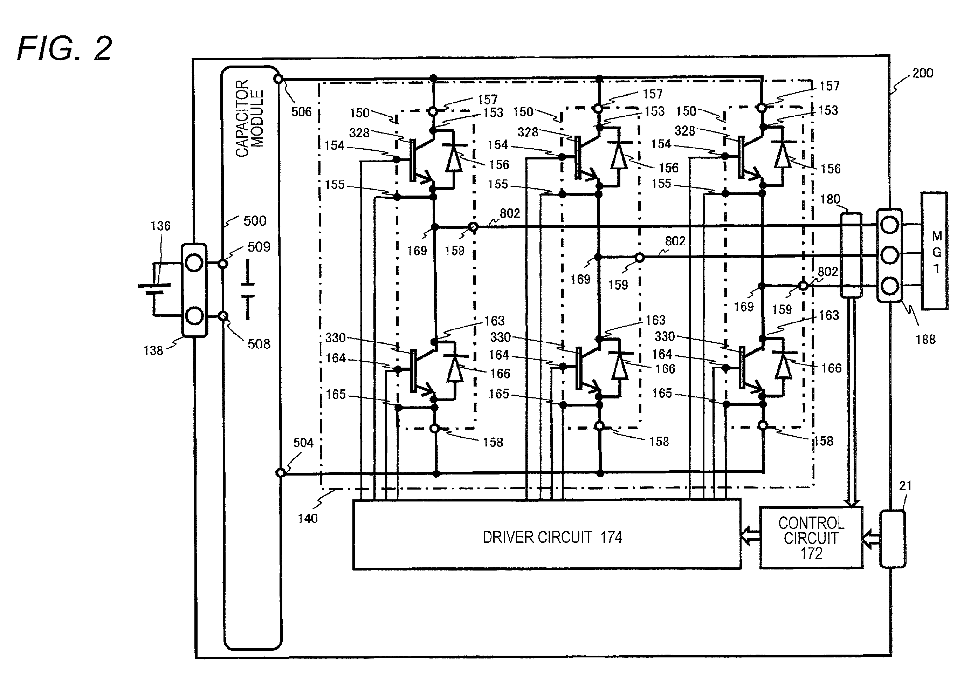

Next, the configuration of the electrical circuit of the inverter circuit 140 will be described with reference to FIG. 2. Hereinafter, an insulated gate bipolar transistor is used as a semiconductor device and will be abbreviated as an IGBT. A series circuit 150 of the upper and lower arms is configured by an IGBT 328 and a diode 156 operating as the upper arm and an IGBT 330 and a diode 166 operating as the lower arm. The inverter circuit 140 is equipped with this series circuit 150 in correspondence with each one of three phases, which are U, V, and W phases, of the AC power to be output.

In this embodiment, these three phases respectively correspond to each phase winding of three phases of the armature winding of the electrical motor generator MG1. The series circuit 150 of each upper and lower arms of each one of the three phases outputs an AC current from a neutral point 169 that is a middle point of the series circuit. This neutral point 169 is connected to an AC busbar 802, which will be described below, which is an AC power line toward the electrical motor generator MG1 through an AC terminal 159 and an AC terminal 188.

The collector 153 of the IGBT 328 of the upper arm is electrically connected to a capacitor terminal 506 that is disposed on the positive side of the capacitor module 500 through a positive terminal 157. In addition, the emitter of the IGBT 330 of the lower arm is electrically connected to a capacitor terminal 504 that is disposed on the negative side of the capacitor module 500 through a negative terminal 158.

The control circuit 172 receives a control instruction through the connector 21 from an upper-level control device, generates a control pulse based on the control instruction, and supplies the generated control pulse to the driver circuit 174. The control pulse is a control signal that is used for controlling the IGBT 328 or the IGBT 330 that configures the upper arm or the lower arm of the series circuit 150 of each phase configuring the inverter circuit 140.

The driver circuit 174 supplies drive pulses used for controlling the IGBT 328 and the IGBT 330 configuring the upper arm and the lower arm of the series circuit 150 of each phase to the IGBT 328 and the IGBT 330 of each phase based on the above-described control pulse. Each one of the IGBT 328 and the IGBT 330 converts the DC power supplied from the battery 136 into three-phase AC power by performing a conduction operation or a blocking operation based on a drive pulse transmitted from the driver circuit 174. This converted power is supplied to the electrical motor generator MG1.

The IGBT 328 is equipped with a collector 153, an emitter 155 used for a signal, and a gate 154. The IGBT 330 is equipped with a collector 163, an emitter 165 used for a signal, and a gate 164. The diode 156 is electrically connected between the collector 153 and the emitter 155. The diode 166 is electrically connected between the collector 163 and the emitter 165.

As a power semiconductor used for switching, a metal oxide semiconductor field effect transistor (hereinafter, abbreviated to a MOSFET) may be used. In such a case, the diode 156 and the diode 166 are unnecessary. As the power semiconductor device used for switching, the IGBT is suitable for a case where the DC voltage is relatively high, and the MOSFET is suitable for a case where the DC voltage is relatively low.

The capacitor module 500 is equipped with a positive-side capacitor terminal 506, a negative-side capacitor terminal 504, a positive-side power source terminal 509, and a negative-side power source terminal 508. A high-voltage DC power supplied from the battery 136 is supplied to the positive-side power source terminal 509 and the negative-side power source terminal 508 through the DC connector 138 and is supplied to the inverter circuit 140 from the positive-side capacitor terminal 506 and the negative-side capacitor terminal 504 of the capacitor module 500.

Meanwhile, the DC power that has been converted from the AC power by the inverter circuit 140 is supplied from the positive-side capacitor terminal 506 and the negative-side capacitor terminal 504 to the capacitor module 500, is supplied to the battery 136 from the positive-side power source terminal 509 and the negative-side power source terminal 508 through the DC connector 138, and is stored in the battery 136.

The control circuit 172 is equipped with a microcomputer (hereinafter, referred to as a microcomputer) that is used for calculating and processing the switching timing of the IGBT 328 and the IGBT 330. As input information that is input to the microcomputer, there are a target torque value required for the electrical motor generator MG1, a current value supplied to the electrical motor generator MG1 from the series circuit 150, and a magnetic pole position of the rotator of the electrical motor generator MG1.

The target torque value is based on an instruction signal that is output from a higher-level control device (not illustrated). The current value is detected based on a detection signal according to a current sensor module 180 to be described later. The magnetic pole position is detected based on a detection signal that is output from the rotating magnetic sensor (not illustrated) of a resolver or the like that is disposed in the electrical motor generator MG1. In this embodiment, although a case is described as an example in which three-phase current values are detected by the current sensor module 180, it may be configured such that current values corresponding to two phases are detected, and currents corresponding to three phases are acquired through calculation.

The microcomputer disposed inside the control circuit 172 calculates d-axis and q-axis current instruction values of the electrical motor generator MG1 based on the target torque value, calculates d-axis and q-axis voltage instruction values based on the d axis and q axis current instruction values, which have been calculated, and a difference between the d-axis and q-axis current values that have been detected, and converts the d-axis and q-axis voltage instruction values, which have been calculated, into U-phase, V-phase, and W-phase voltage instruction values based on the detected magnetic pole position. Then, the microcomputer generates a pulse-shaped modulation wave based on comparison between a fundamental wave (sinusoidal wave) and a carrier wave (triangular wave) that are based on the U-phase, V-phase, and W-phase voltage instruction values and outputs the generated modulation wave to the driver circuit 174 as a PWM (pulse width modulation) signal.

In a case where the lower arm is to be driven, the driver circuit 174 outputs a drive signal that is acquired by amplifying a PWM signal to the gate of the IGBT 330 of the corresponding lower arm. On the other hand, in a case where the upper arm is to be driven, the driver circuit 174 shifts the level of the reference voltage of the PWM signal to the level of the reference voltage of the upper arm, then amplifies the PWM signal, and outputs the amplified signal to the gate of the IGBT 328 of the corresponding upper arm as a drive signal.

In addition, the microcomputer disposed inside the control circuit 172 performs fault detection (over current, over voltage, over temperature, or the like), thereby protecting the series circuit 150. For this, sensing information is input to the control circuit 172. For example, from the emitter 155 used for signaling of each arm and the emitter 165 used for signaling, information of currents flowing through the emitters of the IGBT 328 and the IGBT 330 is input to corresponding ICs. In this way, each IC detects an over current and stops the switching operations of the corresponding IGBTs 328 and 330 in a case where an over current is detected, thereby protecting the corresponding IGBTs 328 and 328330 from over current.

From a temperature sensor (not illustrated) disposed in the series circuit 150, information of the temperature of the series circuit 150 is input to the microcomputer. In addition, information of the voltage of the DC positive side of the series circuit 150 is input to the microcomputer. The microcomputer performs detection of an over temperature and detection of an over voltage based on such information and stops the switching operations of all the IGBTs 328 and 330 in a case where an over temperature or an over voltage is detected.

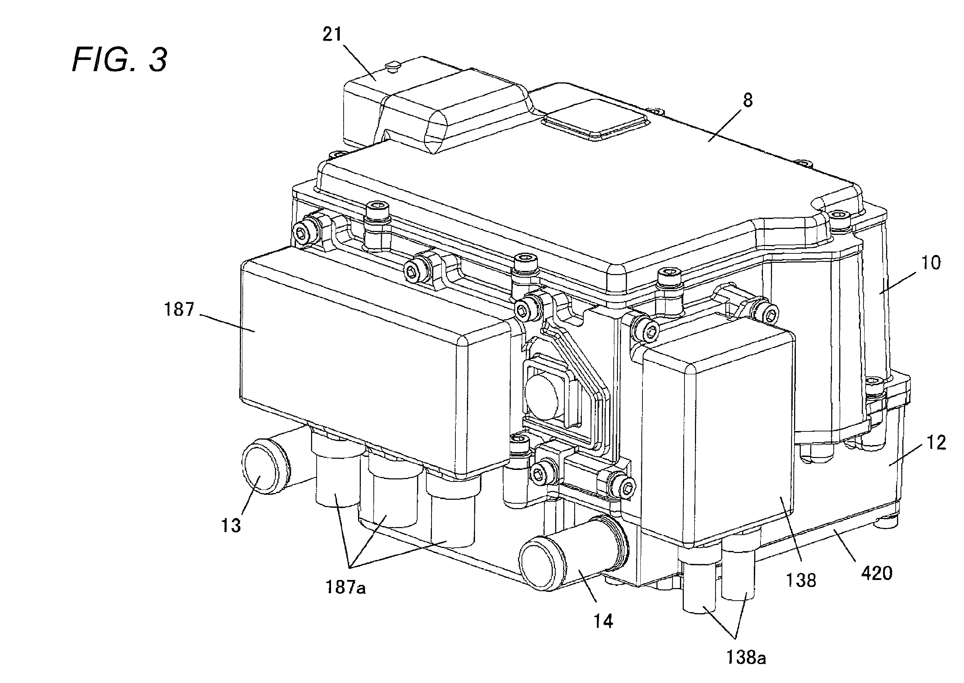

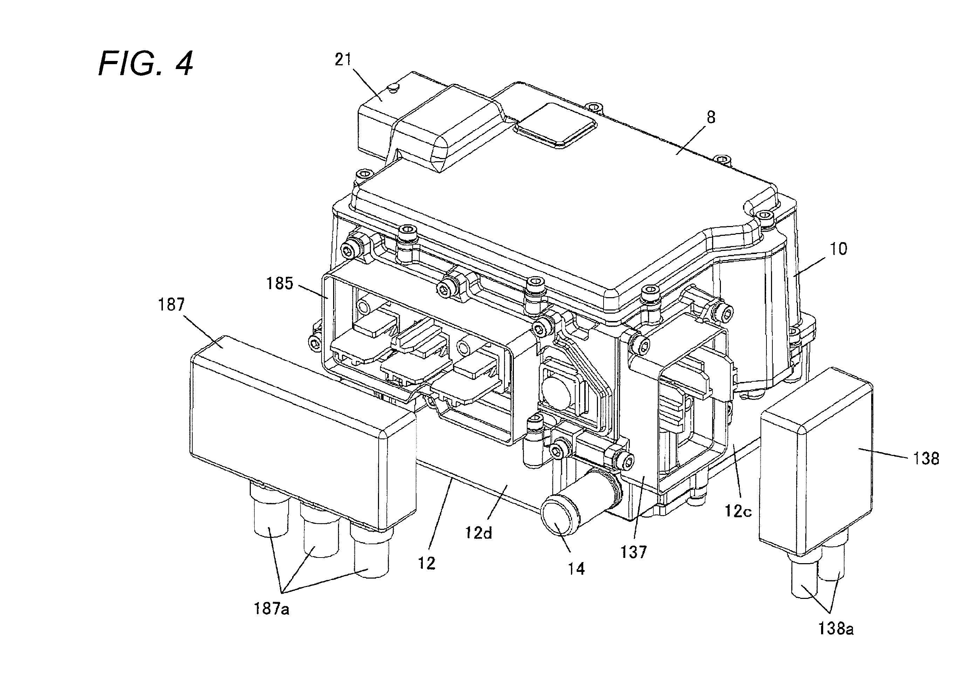

FIG. 3 is an external perspective view of the power inverter 200, and FIG. 4 illustrates a state acquired by excluding the AC connector 187 and the DC connector 138 from the power inverter 200 illustrated in FIG. 3. By forming the power inverter 200 according to this embodiment to have a planar shape of a rectangular parallelepiped having an almost regular square, a decrease in size is achieved, and there is an advantage of enabling the power inverter to be easily mounted in a vehicle. Here, reference numeral 8 represents a lid, reference numeral 10 represents a chassis, reference numeral 12 represents a cooling block, reference numeral 13 represents an inlet pipe of a cooling medium, reference numeral 14 represents an outlet pipe, and reference numeral 420 represents a bottom cover. The lid 8, the chassis 10, the cooling block 12, and the bottom cover 420 configure the casing of the power inverter 200. The connector 21 is a connector for signaling that is disposed for a connection with the outside.

The lid 8 is fixed to an upper opening portion of the chassis 10 in which circuit components configuring the power inverter 200 are housed. The cooling block 12 fixed to a lower portion of the chassis 10 maintains the power module 300 and the capacitor module 500 to be described later and cools them using a cooling medium. As the cooling medium, for example, water is frequently used, and, hereinafter, the cooling medium will be described as cooling water. The inlet pipe 13 and the outlet pipe 14 are disposed on one side face of the cooling block 12, and the cooling water supplied from the inlet pipe 13 flows in a cooling path 19 to be described later inside the cooling block 12 and is discharged from the outlet pipe 14.

An AC interface 185 to which the AC connector 187 is mounted and a DC interface 137 to which a DC connector 138 is mounted are disposed on the side face of the chassis 10. The AC interface 185 is disposed on the side face on which the pipes 13 and 14 are disposed. An AC wiring 187a of the AC connector 187 that is mounted in the AC interface 185 passes between the pipes 13 and 14 and extends to the lower side. The DC interface 137 is disposed on a side face adjacent to the side face on which the AC interface 185 is mounted, and a DC wiring 138a of the DC connector 138 that is mounted in the DC interface 137 also extends to the lower side of the power inverter 200.

In this way, the AC interface 185 and the pipes 13 and 14 are arranged on the side of the same side face 12d, and the AC wiring 187a is drawn out to the lower side to be passed between the pipes 13 and 14. Accordingly, a space occupied by the pipes 13 and 14, the AC connector 187, and the AC wiring 187a can be configured to be small, whereby an increase in size of the entire apparatus can be suppressed. In addition, since the AC wiring 187a is drawn out to the lower side of the pipes 13 and 14, the AC wiring 187a can be easily processed, whereby the productivity is improved.

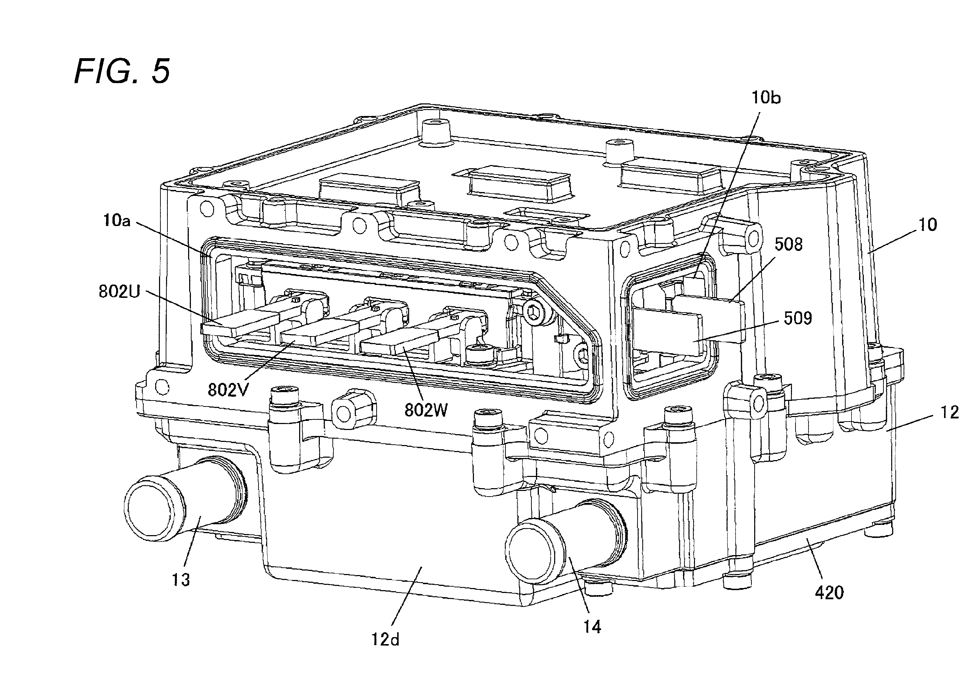

FIG. 5 is a diagram illustrating a state acquired by excluding the lid 8, the DC interface 137, and the AC interface 185 from the power inverter 200 illustrated in FIG. 4. On one side face of the chassis 10, an opening 10a to which the AC interface 185 is fixed is formed, and, on another side face adjacent thereto, an opening 10b to which the DC interface 137 is fixed is formed. Three AC busbars 802, in other words, a U-phase AC busbar 802U, a V-phase AC busbar 802V, and a W-phase AC busbar 802W protrude from the opening 10a, and DC power source terminals 508 and 509 protrude from the opening 10b.

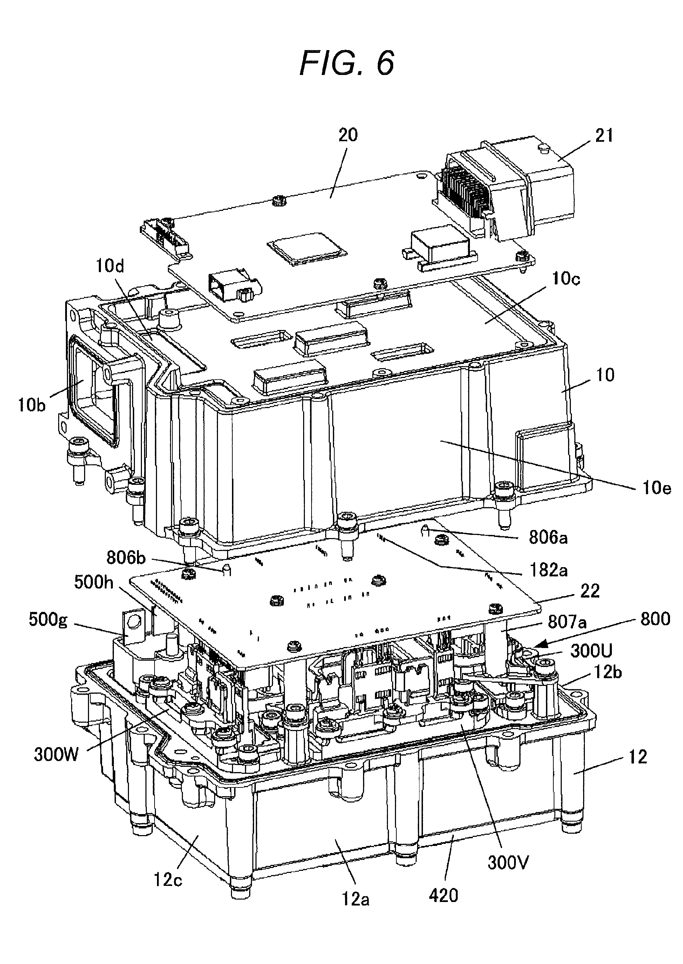

FIG. 6 is a diagram illustrating a state acquired by excluding the chassis 10 from the cooling block 12 illustrated in FIG. 5. The chassis 10 has two housing spaces and is partitioned into an upper housing space and a lower housing space by a partition wall 10c. In other words, the chassis 10 serving as an upper casing together with the lid 8 is equipped with a side wall 10e and the partition wall 10c that is a top plate, the control circuit board 20 to which the connector 21 is connected is fixed to the upper face of the partition wall 10c, and, in the lower housing space disposed on the lower side of the partition wall 10c, a driver circuit board 22 and a busbar assembly 800 to be described later are housed. In the control circuit board 20, the control circuit 172 illustrated in FIG. 2 is mounted, and, in the driver circuit board 22, the driver circuit 174 is mounted.

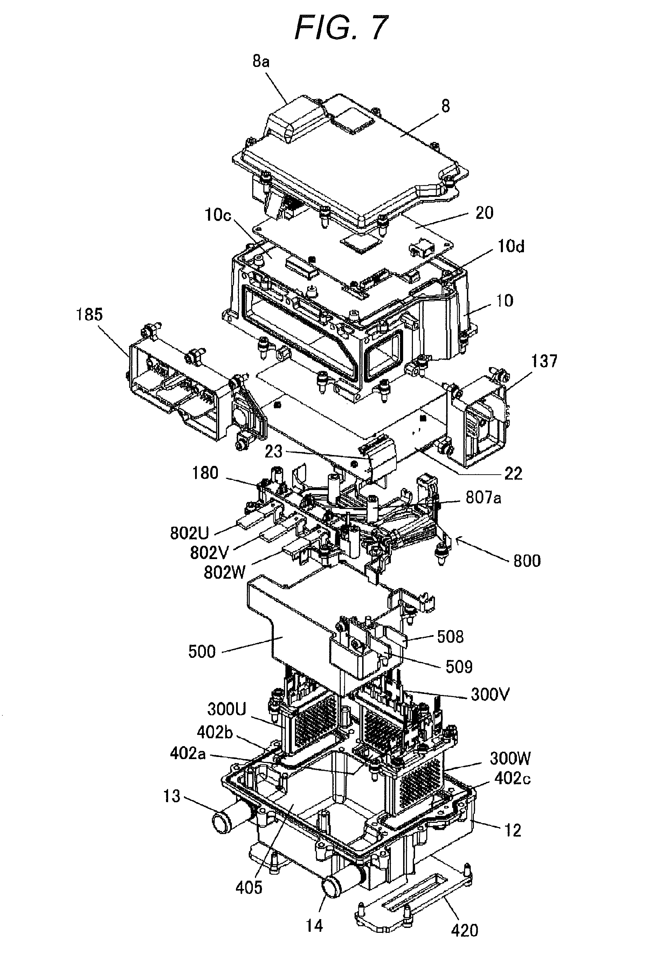

The busbar assembly 800 is fixed to the cooling block 12 using a bolt or the like. In the busbar assembly 800, a plurality of posts 807a protruding upwardly are disposed, and the driver circuit board 22 is fixed on such posts 807a. In other words, the driver circuit board 22 is arranged on the upper side of the busbar assembly 800 so as to face it. The control circuit board 20 and the driver circuit board 22 are connected to each other using a flat cable 23 (see FIG. 7 to be described later). The flat cable is drawn out from the lower housing space to the upper housing space through a slit-shaped opening 10d that is formed in the partition wall 10c.

FIG. 7 is an exploded perspective view of the power inverter 200. On the inner side of the lid 8, in other words, in the upper housing space of the chassis 10, the control circuit board 20 in which the control circuit 172 is mounted as described above is arranged. In the lid 8, an opening 8a used for the connector 21 is formed. A low-voltage DC power that operates the control circuit disposed inside the power inverter 200 is supplied from the connector 21.

As will be described later, in the cooling block 12, a cooling path in which cooling water flows in from the inlet pipe 13 is formed. As the cooling path, a cooling path having the shape of "U" flowing along three side faces of the cooling block 12 is formed. The cooling water flowing in from the inlet pipe 13 flows into the inside of the cooling path from one end of the cooling path having the shape of "U", flows through the inside of the cooling path, and then flows out from the outlet pipe 14 that is connected to the other end of the cooling path.

On the upper face of the cooling path, three opening portions 402a to 402c are formed, and power modules 300U, 300V, and 300W each having the series circuit 150 (see FIG. 1) built therein are inserted into the inside of the cooling path from the opening portions 402a to 402c. A U-phase series circuit 150 is built in the power module 300U, a V-phase series circuit 150 is built in the power module 300V, and a W-phase series circuit 150 is built in the power module 300W. These power modules 300U to 300W have the same configuration, and the exterior shapes thereof are the same as well. The opening portions 402a to 402c are filled with flange portions of the inserted power modules 300U to 300W.

In the cooling block 12 that configures the lower casing together with the bottom cover 420, a housing space 405 used for housing an electrical component is formed so as to be surrounded by the cooling path having the shape of "U". In this embodiment, the capacitor module 500 is housed in this housing space 405. The capacitor module 500 housed in the housing space 405 is cooled by the cooling water flowing inside the cooling path. On the upper side of the capacitor module 500, the busbar assembly 800 in which the AC busbars 802U to 802W are mounted is arranged. The busbar assembly 800 is fixed to the upper face of the cooling block 12. The current sensor module 180 is fixed to the busbar assembly 800.

The driver circuit board 22 is arranged on the upper side of the busbar assembly 800 by being fixed to the post 807a that is disposed in the busbar assembly 800. As described above, the control circuit board 20 and the driver circuit board 22 are connected to each other using the flat cable 23. The flat cable 23 is drawn out from the lower housing space toward the upper housing space through the slit-shaped opening 10d that is formed in the partition wall 10c.

In this way, the power modules 300U to 300W, the driver circuit board 22, and the control circuit board 20 are hierarchically arranged in the height direction, and the control circuit board 20 is arranged at the farthest place from the power modules 300U to 300W having strong electric fields, whereby mixing of a switching noise or the like into the control circuit board 20 side can be reduced. In addition, since the driver circuit board 22 and the control circuit board 20 are arranged in mutually-different housing spaces partitioned by the partition wall 10c, the partition wall 10c serves as an electromagnetic shield, and accordingly, a noise that is mixed into the control circuit board 20 from the driver circuit board 22 can be reduced. The chassis 10 is formed using a metal material such as aluminum.

In addition, since the control circuit board 20 is fixed to the partition wall 10c that is formed integrally with the chassis 10, the mechanical resonance frequency of the control circuit board 20 becomes high for the vibration propagating from the outside. Accordingly, it is difficult for the vehicle side to be influenced by the vibration, and the reliability is improved.

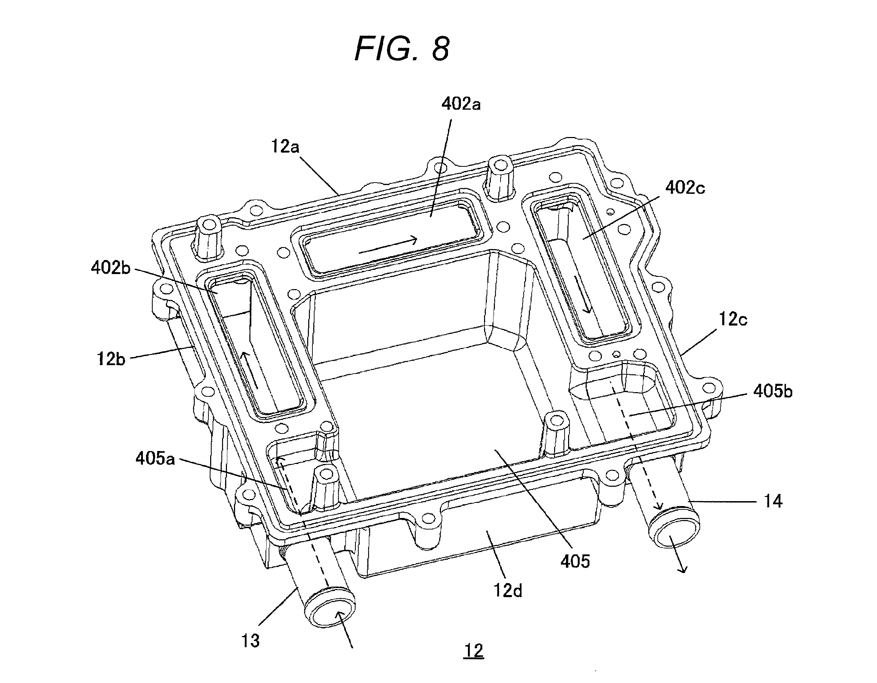

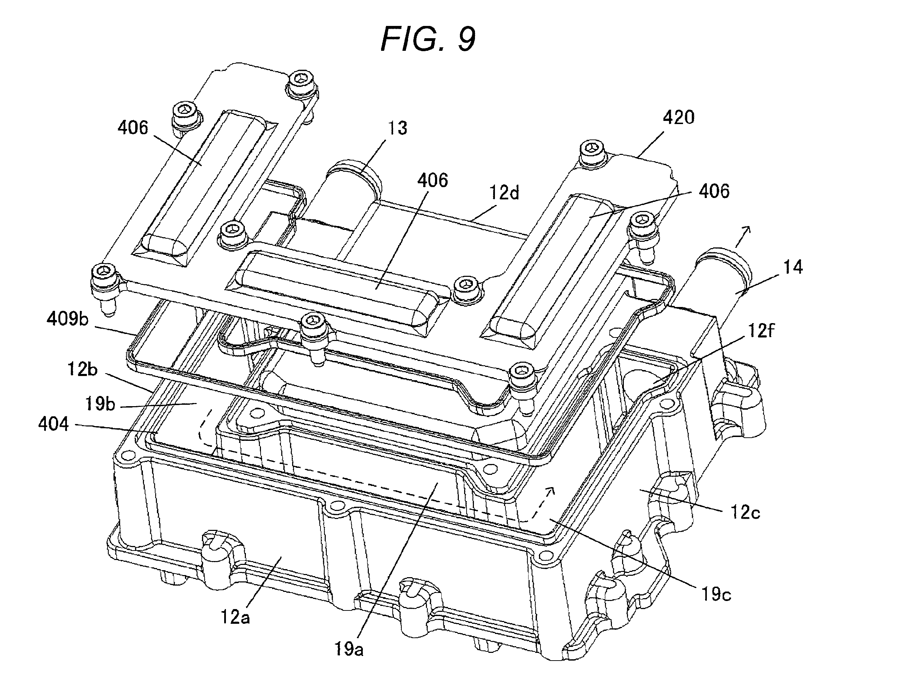

FIG. 8 is a perspective view of the lower casing that is configured by the cooling block 12 and the bottom cover 420. FIG. 9 is an exploded perspective view of the lower casing seen from the rear face side. As illustrated in FIG. 8, the cooling block 12 has a planar shape of a rectangular parallelepiped having an almost regular square and the inlet pipe 13 and the outlet pipe 14 are disposed on the side face 12d thereof. In addition, the side face 12d is formed such that portions in which the pipes 13 and 14 are disposed have a level difference. As illustrated in FIG. 9, the cooling path 19 (19a, 19b, and 19c) is formed in the shape of "U" along the remaining three side faces 12a to 12c. On the rear-face side of the cooling block 12, an opening portion 404 having the shape of "U" connected as one, which has a shape that is almost the same as that of the transverse cross-section of the cooling path 19, is formed. This opening portion 404 is filled with the bottom cover 420 having the shape of "U". A sealing member 409a is disposed between the bottom cover 420 and the cooling block 12, whereby sealing performance is achieved.

The cooling path 19 forming the shape of "U" is divided into three cooling path sections 19a, 19b, and 19c along the direction of the flow of the cooling water. Although described later in detail, the first cooling path section 19a is disposed along the side face 12a positioned to face the side face 12d on which the pipes 13 and 14 are disposed, the second cooling path section 19b is disposed along the side face 12b that is adjacent to one side of the side face 12a, and the third cooling path section 19c is disposed along the side face 12c that is adjacent to the other side of the side face 12a. The cooling water flows in the cooling path section 19b from the inlet pipe 13, as illustrated in the broken-line arrow, flows in order of the cooling path section 19b, the cooling path section 19a, and the cooling path section 19c, and flows out from the outlet pipe 14.

As illustrated in FIG. 8, on the upper side face of the cooling block 12, a rectangular opening portion 402a that is parallel to the side face 12a is formed at a position facing the cooling path section 19a, a rectangular opening portion 402b that is parallel to the side face 12b is formed at a position facing the cooling path section 19b, and a rectangular opening portion 402c that is parallel to the side face 12c is formed at a position facing the cooling path section 19c. Through such opening portions 402a to 402c, the power modules 300U to 300W are inserted into the cooling path 19.

As illustrated in FIG. 9, in the bottom cover 420, convex portions 406 protruding toward the lower side of the cooling path 19 are formed at positions facing the above-described opening portions 402a to 402c. Such convex portions 406 are hollow places when seen from the cooling path 19 side, and the lower end portions of the power modules 300U to 300W inserted from the opening portions 402a to 402c fill in such hollow places. The cooling block 12 is formed such that the opening portion 404 and the opening portions 402a to 402c face each other, and accordingly, a configuration that can be easily manufactured through aluminum casting is formed.

As illustrated in FIG. 8, in the cooling block 12, a housing space 405 that has three sides being surrounded by the cooling path 19 and has a rectangular shape is disposed. In this housing space 405, the capacitor module 500 is housed. Since the housing space 405 surrounded by the cooling path 19 has a rectangular parallelepiped shape, the capacitor module 500 can be formed to have a rectangular parallelepiped shape, whereby the productivity of the capacitor module 500 increases.

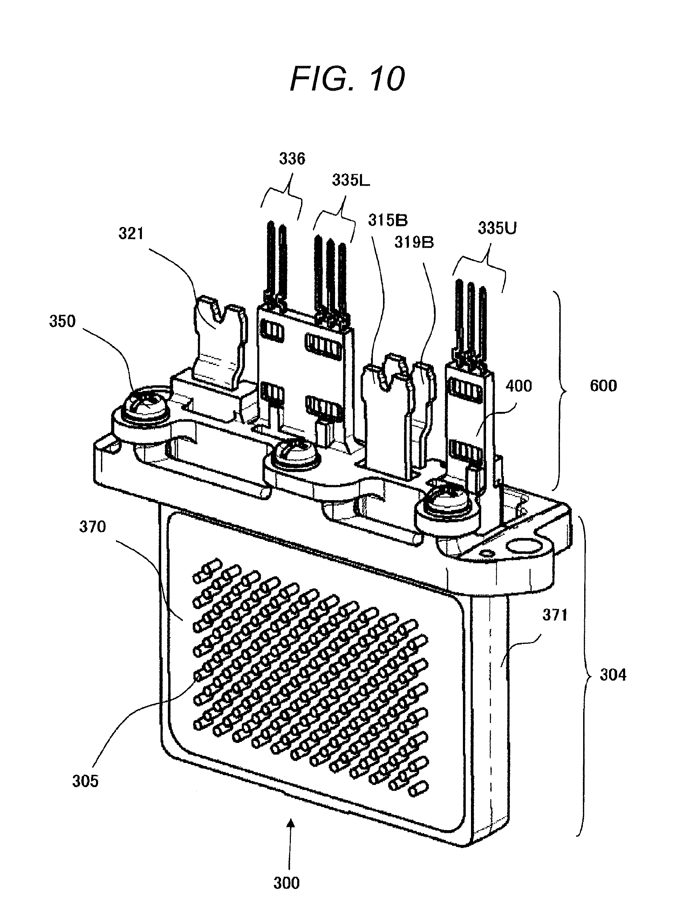

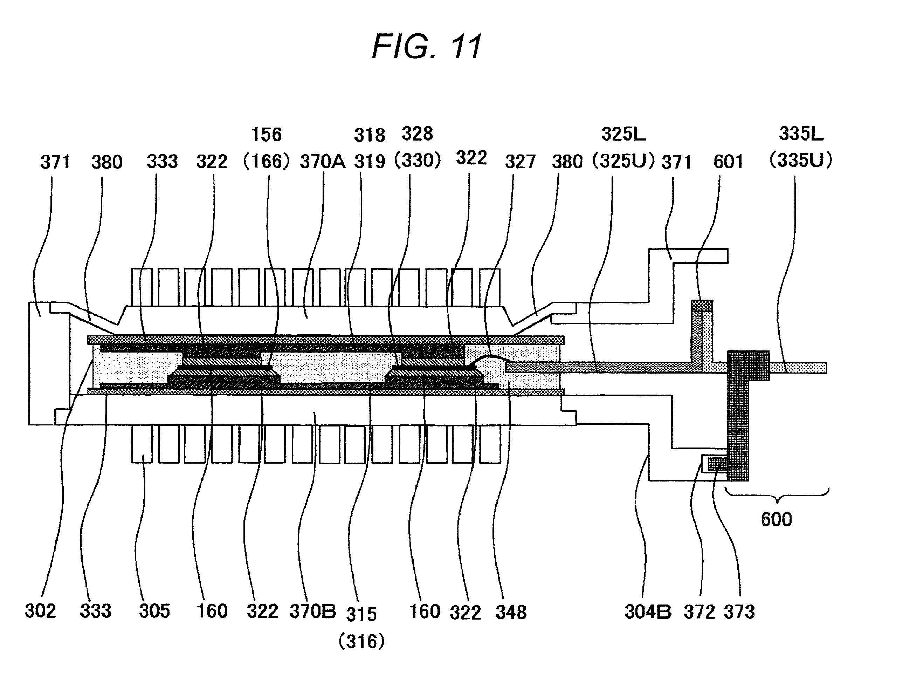

FIG. 10 is a perspective view of the power module. FIG. 11 is a cross-sectional view of the power module. The power modules 300U to 300W described above have the same structure, and one thereof (denoted by 300) is illustrated in FIG. 10. In FIGS. 10 and 11, a signal terminal 335U corresponds to the gate 154 illustrated in FIG. 2, a signal terminal 335L corresponds to the gate 164 illustrated in FIG. 2, and a signal terminal 336 corresponds to a signal terminal that is connected to the emitters 155 and 165 used for signaling illustrated in FIG. 2. In addition, a DC positive terminal 315B corresponds to the positive terminal 157 illustrated in FIG. 2, a DC negative terminal 319B corresponds to the negative terminal 158 illustrated in FIG. 2, and an AC terminal 321 corresponds to the AC terminal 159 illustrated in FIG. 2.

As illustrated in FIGS. 10 and 11, the power module 300U is acquired by enclosing a module sealing body 302 sealed by a sealing resin 348 inside a module case 304 that is a can-type cooler. Here, the can-type cooler is a cooler of a can shape having an insertion opening on one face and a bottom on the other face. In the insertion opening portion of the module case 304, a relay terminal 600 can be assembled which is formed by integrally molding the DC positive terminal 315B, the DC negative terminal 319B, the AC terminal 321, and the signal terminals 335U and 335L.

As illustrated in FIG. 11, the module case 304 is formed by a frame body 371, a first cooling member 370A, and a second cooling member 370B. On the outer face of the first cooling member 370A and the second cooling member 370B, a plurality of pins 305 are arranged. For bonding the frame body 371 and the cooling members 370A and 370B together, for example, melt welding, solid phase bonding, or the like is used.

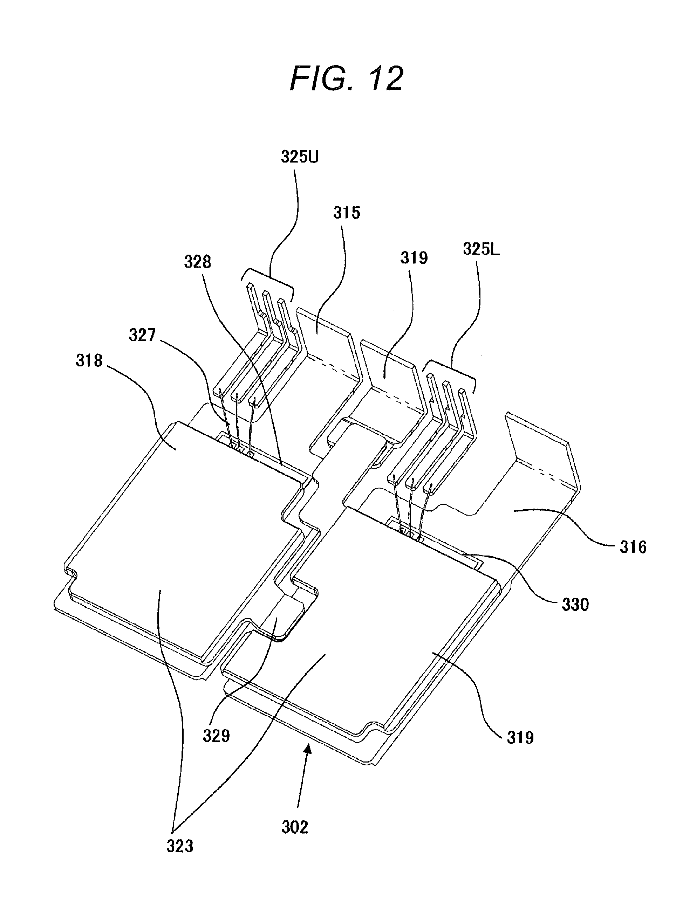

FIG. 12 is a perspective view of a module sealing body 302, and the sealing resin 348 is not illustrated so as to allow the internal configuration thereof to be understandable. A DC positive-side conductive plate 315 and an AC output-side conductive plate 316 are arranged on an approximately same plane. As illustrated in FIG. 11, the collector of the upper arm-side IGBT 328 and the cathode of the upper arm-side diode 156 are firmly fixed to the conductive plate 315. In addition, the collector of the lower arm-side IGBT 330 and the cathode of the lower arm-side diode 166 are firmly fixed to the conductive plate 316.

Similarly, the AC conductive plate 318 and the DC conductive plate 319 are arranged on an approximately same plane. The emitter of the upper arm-side IGBT 328 and the anode of the upper arm-side diode 156 are firmly fixed to the AC conductive plate 318. The emitter of the lower arm-side IGBT 330 and the anode of the lower arm-side diode 166 are firmly fixed to the conductive plate 319. In addition, as illustrated in FIG. 11, each power semiconductor device is firmly fixed to a device fixing portion 322, which is disposed in each conductive plate, having a convex shape through a metal bonding material 160. The metal bonding material 160, for example, is a solder material, a low-temperature sintering bonding material containing a silver sheet and fine metal particles, or the like.

Each power semiconductor device is a plate-type flat structure, and electrodes of the power semiconductor device are formed on the front and rear faces. As illustrated in FIG. 11, the power semiconductor device is interposed between the conductive plates 315 and 318 or the conductive plates 316 and 319. In other words, the conductive plates 315 and 318 face each other to be approximately parallel to each other through the IGBT 328 and the diode 156, thereby forming a laminated arrangement. Similarly, the conductive plates 316 and 319 face each other to be approximately parallel to each other through the IGBT 330 and the diode 166, thereby forming a laminated arrangement. In addition, the conductive plates 316 and 318 are connected to each other through a neutral point 329. Through this connection, the upper arm circuit and the lower arm circuit are electrically connected to each other, whereby an upper and lower arm series circuit is formed.

In addition, as substitutes for the IGBTs 328 and 330, a metal-oxide semiconductor field-effect transistor (MOSFET) may be used. Furthermore, as the metal bonding material 160, lead-free solder having high thermal conductivity and a superior environmental property or the like, for example, Sn-Cu solder, Sn-Ag-Cu solder, Sn-Ag-Cu-Bi solder, or the like may be used.

After the power semiconductor device is firmly fixed to be interposed between both faces of the conductive plates, a signal electrode used for a connection with the driver board is mounted. The gate of the upper arm-side IGBT 328 and the signal terminal 325U and the gate of the lower arm-side IGBT 330 and the signal terminal 325L are respectively connected through wire bonding 327, ribbon bonding, or the like. As the material of the wire and the ribbon, aluminum may be used. In addition, the signal terminal 325U may be connected to the gate using the metal bonding material 160 such as solder. As the material of the signal terminal 325U, pure copper or copper alloy may be used.

The module sealing body 302 connected to the signal electrode is sealed using the sealing resin 348 so as to improve the reliability and maintain the conductive plates. The sealing resin 348 is molded through transfer molding using an epoxy resin. At that time, since the outer faces 323 of the conductive plates 315, 316, 318, and 319 serve as cooling faces toward the module case 304, the outer faces thereof are exposed from the sealing resin 348. It is preferable that the exposed area be larger than the area of the convex portion. From this, a thermal conduction path can be secured, and accordingly, the cooling performance can be expected to be improved.

The relay terminal 600 used for a connection with the driver circuit board 22 is bonded to the module sealing body 302 for which transfer molding has been performed. The DC positive terminal 315B is bonded to the conductive plate 315, the DC negative terminal 319B is bonded to the conductive plate 319, and the AC terminal 321 is bonded to the conductive plate 316. The signal terminals 325U and 325L are respectively bonded to the signal terminals 335U and 335L. As a bonding method, melt welding or solid-phase bonding is used. As illustrated in FIG. 10, insertion molding is performed for each terminal disposed in the relay terminal 600 using a resin 400 such as PPS (polyphenylene sulfide) or the like.

In order to enclose the module sealing body 302 in the module case 304, a high thermal conductance insulating layer 333 (FIG. 11) is arranged in the module sealing body 302, the module case 304 is pressed, and the first and second cooling members 370A and 370B and the module sealing body 302 are bonded together using the high thermal conductance insulating layer 333. At that time, an outer circumferential portion 380 of the first cooling member 370A is deformed first, whereby the second cooling member 370B and the frame body 371 can be prevented from being deformed. In addition, when the module sealing body 302 is inserted into the module case 304, by mechanically fixing the module sealing body 302 and the module case 304 using screws 350 (see FIG. 10), the module sealing body 302 and the module case 304 are positioned. Finally, by injecting a resin into a gap arranged inside the module case 304 and solidifying the resin, the entire module sealing body 302 is sealed.

The high thermal conductance insulating layer 333 according to this embodiment is formed by a resin sheet acquired by dispersing ceramic particles in an epoxy resin. In order to improve the reliability of adherence of the cooling sheet, a bonding layer may be disposed on the front surface of the cooling sheet in advance. A sheet acquired by coating both faces of a ceramic sheet with cooling grease using the ceramic sheet formed using a material such as aluminum oxide, silicon nitride, or aluminum nitride having thermal conductivity superior to resin may be used. In this embodiment, although the sheet is used, grease, a compound, or the like other than the sheet may be used.

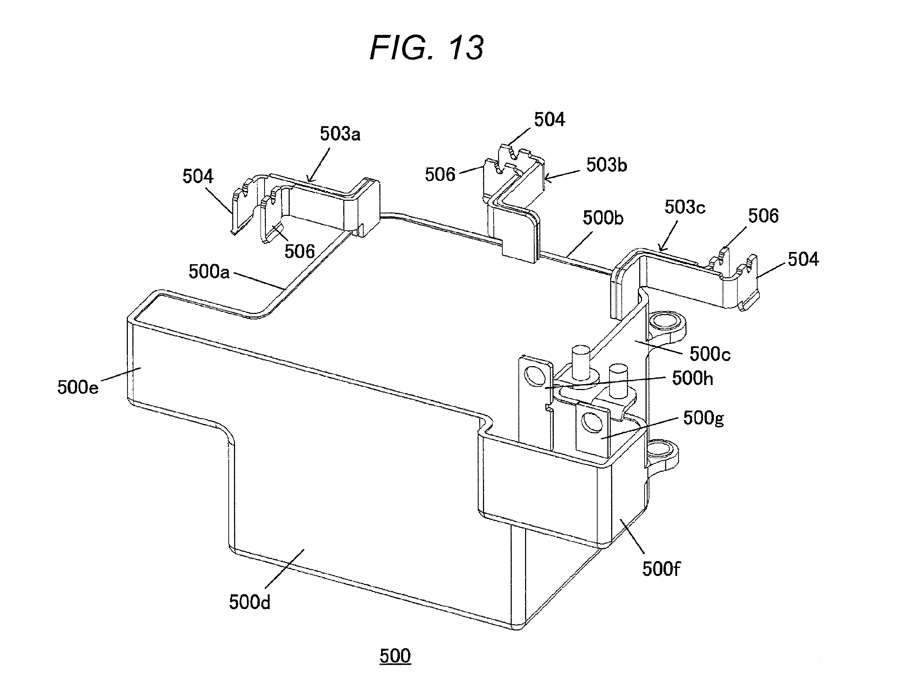

FIG. 13 is an external perspective view of the capacitor module 500. A plurality of capacitor cells are disposed inside the capacitor module 500. On the upper face of the capacitor module 500, capacitor terminals 503a to 503c are disposed to protrude near faces 500a, 500b, and 500c facing the cooling path 19. The capacitor terminals 503a to 503c are formed in correspondence with the positive terminals 157 and the negative terminals 158 of the power modules 300. The capacitor terminals 503a to 503c form the same shape, and an insulating sheet is disposed between the negative-side capacitor terminal 504 and the positive-side capacitor terminal 506 configuring each one of the capacitor terminals 503a to 503c, whereby insulation between the terminals is secured.

In an upper area of the side face 500d of the capacitor module 500, protruded portions 500e and 500f are formed. Inside the protruded portion 500e, a discharge resistor is mounted, and, inside the protruded portion 500f, a Y capacitor used for a common mode noise countermeasure is mounted. In addition, the power source terminals 508 and 509 illustrated in FIG. 5 are mounted in terminals 500g and 500h protruded from the upper face of the protruded portion 500f. As illustrated in FIG. 8, between the opening portions 402b and 402c and the side face 12d, concave portions 405a and 405b are formed, and, when the capacitor module 500 is housed in the housing space 405 of the cooling block 12, the protruded portion 500e is housed in the concave portion 405a, and the protruded portion 500f is housed in the concave portion 405b.

The discharge resistor mounted inside the protruded portion 500e is a resistor that is used for discharging electric charge collected in the capacitor cell inside the capacitor module 500 at the time of stopping the inverter. Since the concave portion 405a in which the protruded portion 500e is housed is disposed right above the cooling path of the cooling water flowing from the inlet pipe 13, an increase in the temperature of the discharge resistor at the time of discharging can be suppressed.

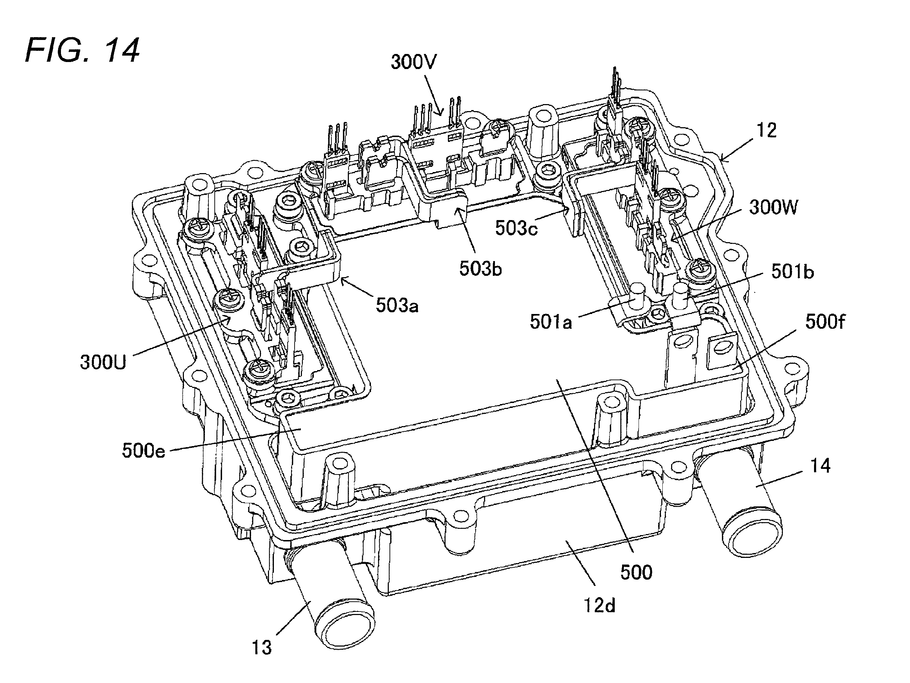

FIG. 14 is a diagram illustrating the cooling block 12 in which the power modules 300U to 300W are fixed to the opening portions 402a to 402c and the capacitor module 500 is housed in the housing space 405. In the example illustrated in FIG. 14, the U-phase power module 300U is fixed to the opening portion 402b, the V-phase power module 300V is fixed to the opening portion 402a, and the W-phase power module 300W is fixed to the opening portion 402c. Thereafter, the capacitor module 500 is housed in the housing space 405, the capacitor-side terminal and the terminal of each power module is connected to each other through welding or the like. Each terminal protrudes from the upper end face of the cooling block 12, and a welding operation is performed with a welding machine being approached from the upper side.

In addition, the positive and negative terminals 157 and 158 of the power modules 300U to 300W each arranged in the shape of "U" are connected to the capacitor terminals 503a to 503c that are disposed to protrude to the upper face of the capacitor module 500. Since the three power modules 300U to 300W are disposed to surround the capacitor module 500, the positional relationships of the power modules 300U to 300W with respect to the capacitor module 500 are equal, and the power modules can be connected to the capacitor module 500 so as to have good balance by using the capacitor terminals 503a to 503c having the same shape. Accordingly, it is easy to balance the circuit constants of the capacitor module 500 and the power modules 300U to 300W at each phase of three phases, whereby a structure is formed in which currents can easily flow in and out.

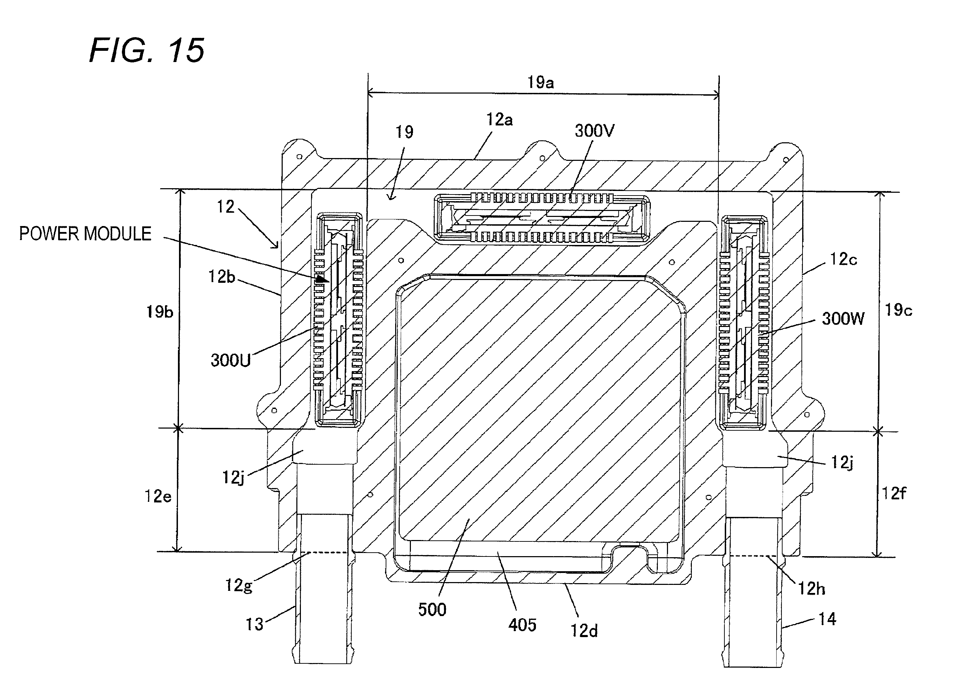

FIG. 15 is a traversal cross-sectional view of the cooling block 12 in which the power modules 300U to 300W and the capacitor module 500 are arranged as illustrated in FIG. 14. As described above, the cooling path 19 having the shape of "U" is formed in the cooling block 12, and, in the cooling path section 19b formed along the side face 12b illustrated on the left side of the figure, the U-phase power module 300U is arranged. Similarly, in the cooling path section 19a formed along the side face 12a disposed on the opposite side of the side face 12d on which the pipes 13 and 14 are disposed, the V-phase power module 300V is arranged, and, in the cooling path section 19c formed along the side face 12c illustrated on the right side, the W-phase power module 300W is arranged.

On the side face 12d of the cooling block 12, openings 12g and 12h are formed. The opening 12g communicates with the cooling path section 19b through a communication path 12e. In addition, the opening 12h communicates with the cooling path section 19c through a communication path 12f. The pipes 13 and 14 arranged in the openings 12g and 12h are attached so as to be pressingly inserted into the communication paths 12e and 12f.

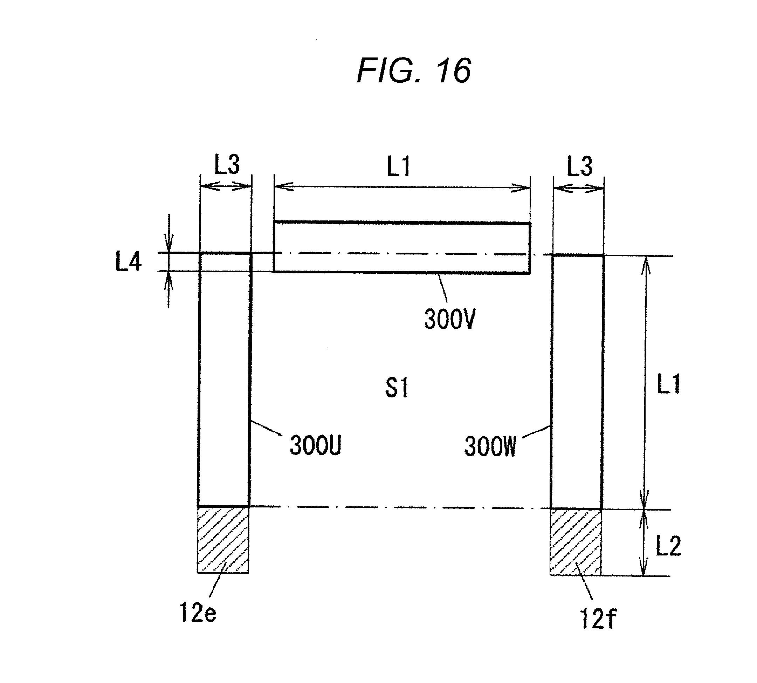

FIG. 16 is a schematic diagram illustrating the arrangement of the three power modules 300U to 300W. The power modules 300U to 300W have the same structure and the same shape. The horizontal width of each one of the side faces 12b and 12c of the cooling block needs to be at least about a sum of a length L1 along the cooling path of the power modules 300U to 300W and a length L2 of the communication path. On the other hand, the horizontal width of the side face 12a needs to be at least about the dimension L1. Actually, as illustrated in FIG. 15, the dimensions need to be slightly adjusted in consideration of the flow of the cooling water of joint portions of the cooling path sections.

Accordingly, in a case where the installation area of the power inverter 200 is to be minimized as possible, by forming the shape (planar shape) in the plan view to be an approximate square, the size of the power inverter 200 can decrease. As described above, since the communication paths are necessary in the direction along the side faces 12b and 12c, from the viewpoint of decreasing the size, as illustrated in FIG. 16, it is preferable that the power module 300V be arranged such that a part of the power module 300V is included in an area S1 formed between the power modules 300U and 300W forming one pair.

As illustrated in FIG. 16, the dimension (the dimension of the horizontal width of the side face 12a) of the arrangement space in the illustrated horizontal direction is at least about L1 + 2·L3 when the thickness of the power module is L3. Thus, by setting L3 and L4 such that the dimension L1 + L2 + (L3 - L4) in the vertical direction is about the same as L1 + L3, the area in the plan view can further decrease, and an approximate square can be formed. At this time, the cooling path section 19a is formed so as to be passed through an area formed between the power modules 300U and 300W as illustrated in FIG. 15. In the example illustrated in FIG. 30, due to a restriction according to the dimension of the capacitor module 500, a gap between the power modules 300U and 300W is slightly larger than the dimension L1 of the power module 300V.

The pipes 13 and 14 and the upper areas of the communication paths 12e and 12f into which the pipes are pressingly inserted are vacant spaces. Thus, as illustrated in FIG. 8, by forming the concave portions 405a and 405b in these spaces and arranging the protruded portion 500e that is a portion for mounting the discharge resistor of the capacitor module 500 and the protruded portion 500f that is a portion for mounting the Y capacitor as illustrated in FIG. 14, the vacant spaces are effectively used, which contributes to a decrease in the size of the power inverter 200. By aggregating the positions of the pipes 13 and 14 on one side face 12d, the flow of the cooling water from the inlet pipe 13 to the cooling path section 19b and from the cooling path section 19c to the outlet pipe 14 forms a linear shape, whereby the pressure drop can be extremely small. In addition, an increase in the installation space required for the device due to the protrusion of the pipes can be suppressed, and the in-vehicle implementation is improved. Furthermore, when the pipes 13 and 14 are pressingly inserted into the communication paths 12e and 12f, the operation for the pressingly inserting thereof is performed only on one face of the casing, and accordingly, the operability and the productivity are improved.

In addition, since the cooling path 19 is disposed to surround three sides of the capacitor module 500, the capacitor module 500 can be effectively cooled. The power inverter 200 according to this embodiment is for the in-vehicle use and, generally, is frequently arranged inside an engine room. Inside the engine room, the temperature is relatively high in accordance with the heat of the engine, the electrical motor for driving and the like, there is a problem of heat penetration into the power inverter 200 from the periphery thereof. However, as illustrated in FIG. 15, since the three sides of the capacitor module 500 is surrounded by the cooling path 19 in which the cooling water flows, the heat penetration from the periphery of the device can be effectively blocked.

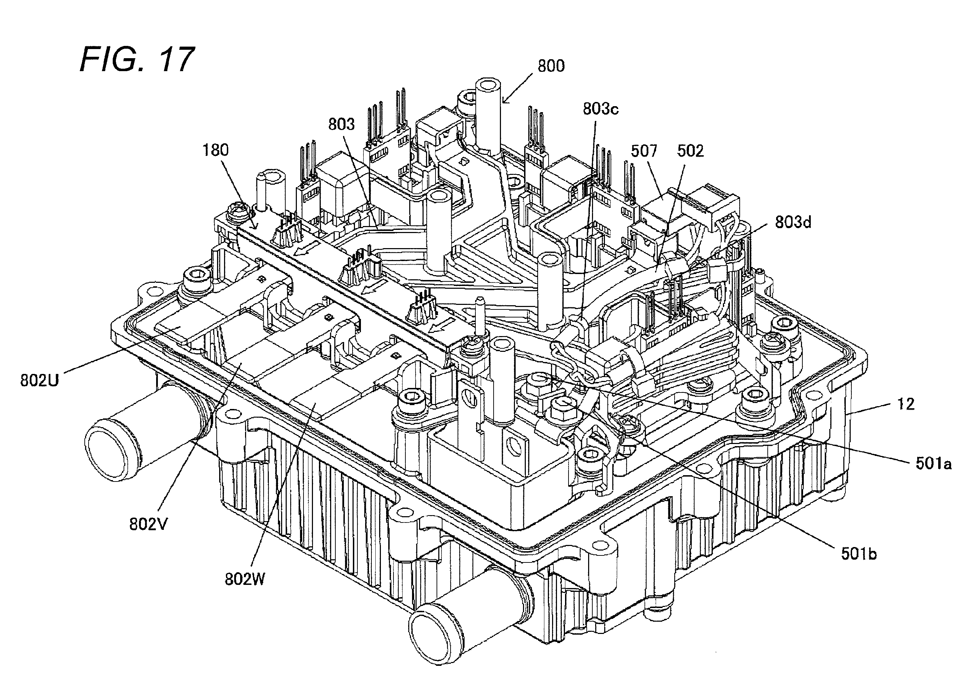

As illustrated in FIG. 14, when the power modules 300U to 300W and the capacitor modules 500 are arranged in the cooling block 12, as illustrated in FIG. 17, the busbar assembly 800 is fixed on the cooling block 12 using bolts so as to be arranged on the upper side of the capacitor module 500, and a welding operation of the terminals is performed. The driver circuit board 22 has the DC power supplied from the battery 136 as the power source.

As illustrated in FIG. 2, the power modules 300U to 300W and the capacitor module 500 are connected in parallel to the DC power source line. As illustrated in FIG. 17, the capacitor module 500 and the driver circuit board 22 are connected to each other through a harness 502. In one end of the harness 502, a connector 507 used for a connection with the driver circuit board 22 is disposed, and the other end of the harness 502 is connected to terminals 501a and 501b that are disposed in the capacitor module 500.

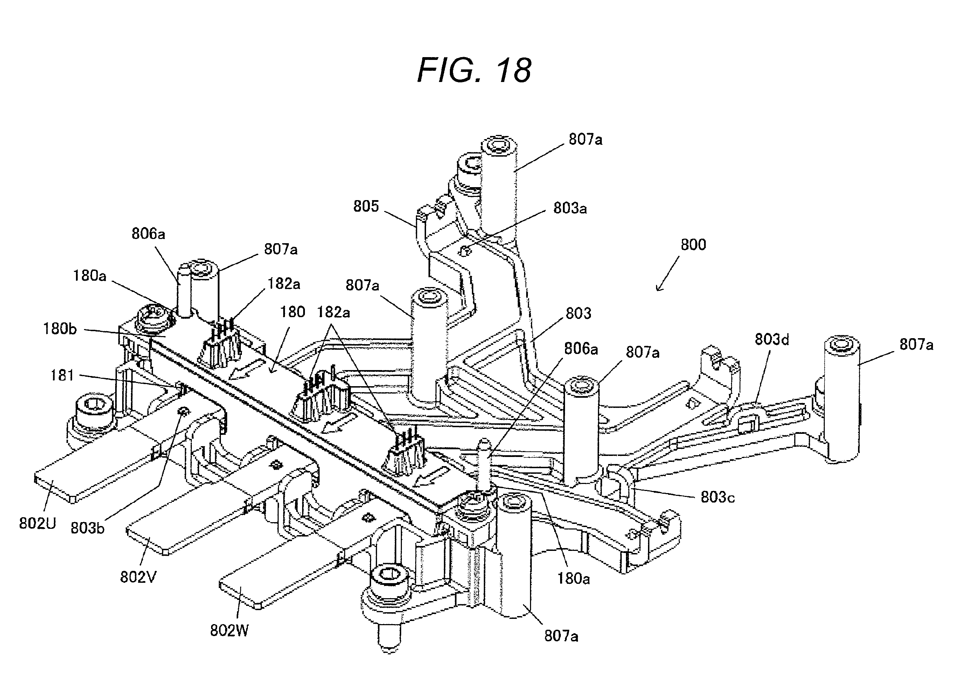

FIG. 18 is a perspective view of the busbar assembly 800. The busbar assembly 800 is equipped with U-phase, V-phase, W-phase AC busbars 802U, 802V, and 802W, a holding member 803 that is used for holding and fixing the AC busbars 802U to 802W, and a current sensor module 180 that is used for detecting AC currents flowing through the AC busbars 802U to 802W. The busbar assembly 800 is fixed on the cooling block 12 using bolts. In this way, since one holding member 803 serves as both the holding member of the AC busbars 802U to 802W and the holding member of the current sensor module 180, the number of components can be decreased.

Each one of the AC busbars 802U to 802W is formed using a wide conductor and is maintained on the upper side (front side) of the holding member 803 that is acquired by coating (molding) a metal base plate with a resin member having an insulation property. On the front face of the holding member 803, a plurality of posts 807a protruding to the upper side are formed. In the upper end portion of the post 807a, an insert having a female screw formed therein is inserted, and the driver circuit board 22 is screwed to be fixed to the upper end of the post 807a. In this way, by holding the AC busbars 802U to 802W and the current sensor module 180 using the holding member 803 that is common thereto and configuring the holding member 803 to serve as a holding member of a plurality of components as well such that the driver circuit board 22 is fixed to the post 807a formed in the holding member 803, the number of components can be decreased, and the size can be decreased.

In addition, a pair of positioning pins 806a are formed on the front side of the holding member 803. On the other hand, on the current sensor module 180 side, through holes 180a which the positioning pins 806a are inserted into and passed through are formed in both end portions in the longitudinal direction. The current sensor module 180 is placed on the holding member 803 from the upper side of the holding member and is screwed to be stopped such that the positioning pins 806a of the holding member 803 are inserted into and passed through the through holes 180a. As a result, the current sensor module 180 is positioned and fixed at a predetermined position of the holding member 803. As illustrated in FIG. 17, when the busbar assembly 800 is fixed on the cooling block 12, the current sensor module 180 is arranged to be parallel with the side face 12d at a position near the side face 12d of the cooling block 12.

On the side face of the current sensor module 180, through holes 181 used for allowing the AC busbars 802U to 802W to be passed therethrough are formed. In the current sensor module 180, three sets of current sensors are arranged in the longitudinal direction inside a long frame body 180b as illustrated in FIG. 18. In the portions in which the through holes 181 through which the busbar is passed are formed, current sensors are disposed, and a lead terminal 182a of each current sensor protrudes from the upper face of the frame body 180b toward the upper side. The busbars 802U to 802W are passed through the through holes 181, and the tip end portions thereof protrude in parallel with one another.

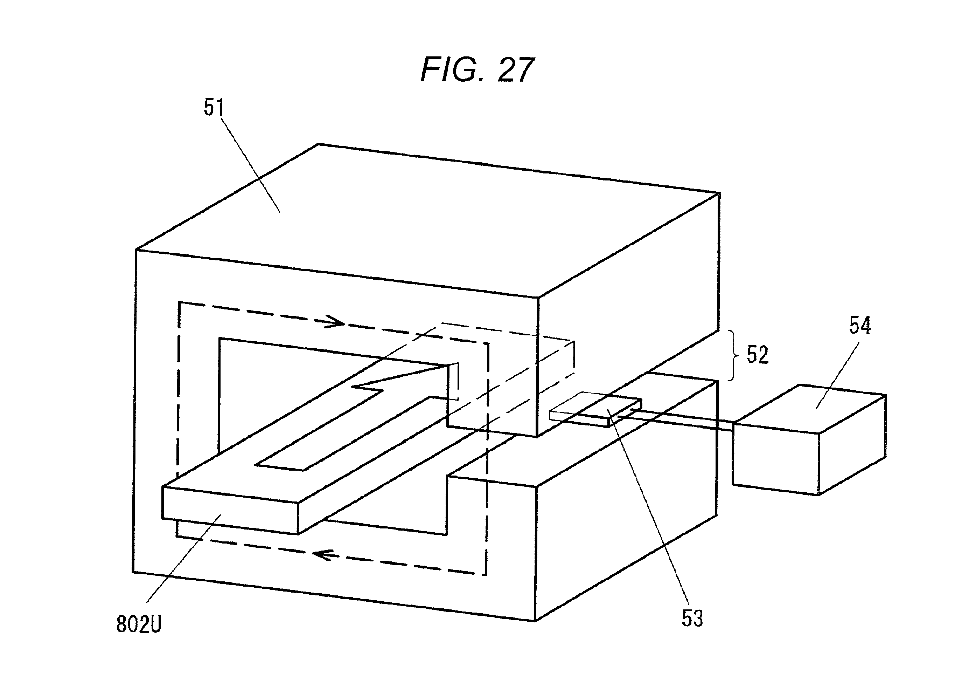

FIG. 27 is a diagram illustrating the configuration of one of three sets of current sensors disposed inside the frame body 180b. In a portion of the frame body 180b in which the through hole 181 is disposed, a C-type sensor core 51 formed using a magnetic material so as to surround the busbar 802U is disposed. In a gap 52 of the sensor core 51, a Hall sensor 53 is disposed as the current sensor. The Hall sensor 53 detects the intensity of the magnetic field in the portion of the gap 52.

Since the relative permeability of the sensor core 51 formed using a magnetic material is higher than that of the air (relative permeability = 1), lines of magnetic flux around the AC busbar 802U are concentrated to be closed inside the sensor core 51. As a result, the magnetic flux in the gap 52 increases, and the sensor sensitivity is improved. A signal output from the Hall sensor 53 is amplified by an amplification circuit 54 and is output from the lead terminal 182a.

The lead terminal 182a is inserted into and passed through the through hole formed in the driver circuit board 22, which is arranged on the upper side of the current sensor module 180, so as to be bonded to the driver circuit board. Accordingly, the positioning pin 806a of the holding member 803 not only determines the position by being passed through the frame body 180b of the current sensor module 180 but also, as illustrated in FIG. 6, is inserted into and passed through the through hole that is formed in the driver circuit board 22.

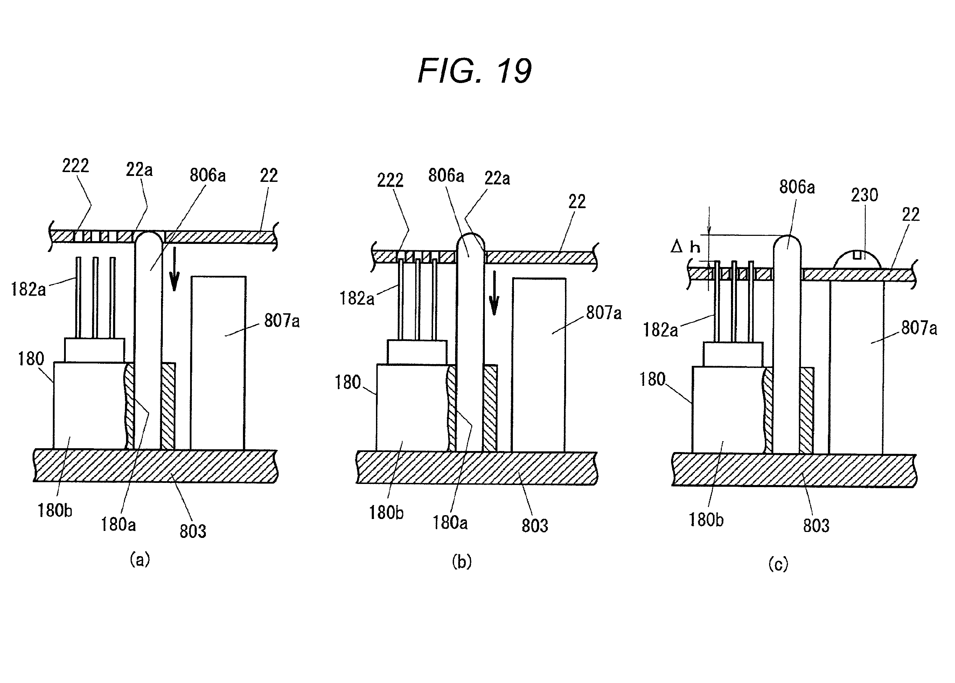

FIG. 19 is a diagram illustrating the positioning of the driver circuit board 22 using the positioning pin 806a and schematically illustrates a portion in which the current sensor module 180 illustrated in FIG. 18 is mounted. As described above, on the holding member 803, the post 807a and the positioning pin 806a are formed to protrude to the upper side illustrated in the figure. The current sensor module 180 is arranged on the holding member 806 such that the positioning pin 806a is inserted into and passed through the through hole 180a formed in the frame body 180b and, as illustrated in FIG. 18, is screwed to be stopped at the holding member 803.

Next, as illustrated in FIG. 19(a), the driver circuit board 22 is moved in the direction (direction of an arrow illustrated in the figure) of the holding member 803 and, as illustrated in FIG. 19(c), is placed on the post 807a such that the positioning pin 806a is inserted into and passed through the through hole 22a formed in the driver circuit board 22. Then, the driver circuit board 22 is fixed to the post 807a by using a screw 230 or the like. In the driver circuit board 22, a through hole 222 used for a connection with the lead terminal 182a of the current sensor module 180 is formed. The tip end of the positioning pin 806a is set to be located higher than the lead terminal 182a of the current sensor module 180 that is fixed to the holding member 803. In other words, Δh represented in FIG. 9(c) is set such that Δh > 0.

Accordingly, when the driver circuit board 22 is placed on the post 807a, as illustrated in FIG. 19(a), first, the positioning pin 806a is inserted into the through hole 22a. Thereafter, the driver circuit board 22 is placed on the post 807a in a state in which the position in the horizontal direction illustrated in the figure is regulated by the positioning pin 806a. As a result, a deviation of the through hole 222 of the driver circuit board 22 with respect to the lead terminal 182a of the current sensor module 180 can be prevented, whereby the operability of the assembly can be improved. It is apparent that almost the same advantages can be acquired whenΔh = 0 is set.

In addition, in this embodiment, since three sensing devices corresponding to three phases are disposed integrally with the current sensor module 180, an assembly error for each sensing device does not occur. For example, in the case of a structure in which three sensing devices are individually mounted on the holding member 803, each sensing device needs to be mounted on the holding member 803 with high precision so as to match the arrangement of the through hole 222 on the driver circuit board 22 and not to generate a positional deviation between the sensing devices. Meanwhile, in this embodiment, the three sensing devices are integrated as the current sensor module 180, and accordingly, a positional deviation between sensing devices does not occur at the time of the assembly process.

As illustrated in FIG. 17, the terminals 501a and 501b of the capacitor module 500 disposed on the lower side of the busbar assembly 800 and the driver circuit board 22 disposed on the upper side of the busbar assembly 800 are connected to each other through the harness 502. The harness 502 detours so as to pass the side of the holding member 803 in which the AC busbars 802U to 802W are maintained and is drawn out from the terminals 501a and 501b to the driver circuit board 22. In the holding member 803, as illustrated in FIG. 18, a claw-shaped protrusion 803c serving as a guide member at the time of pulling out the harness 502 and a hole forming portion 803d used for a tying band are formed. By arranging such guide members, the position of the harness 502 is determined at an appropriate position, and it is easy to pull out the harness 502 without being interfered with the busbar or the terminal.

As portions in which guide members are disposed, at least two portions of a guide member (protrusion 803c) that defines the drawing-out between the terminals 501a and 501b and the holding member 803 and a guide member (hole forming portion 803d) that defines the drawing-out between the holding member 803 and the driver circuit board 22 are necessary. Moreover, instead of using the typing band, the harness may be guided by a plurality of claw-shaped protrusions.

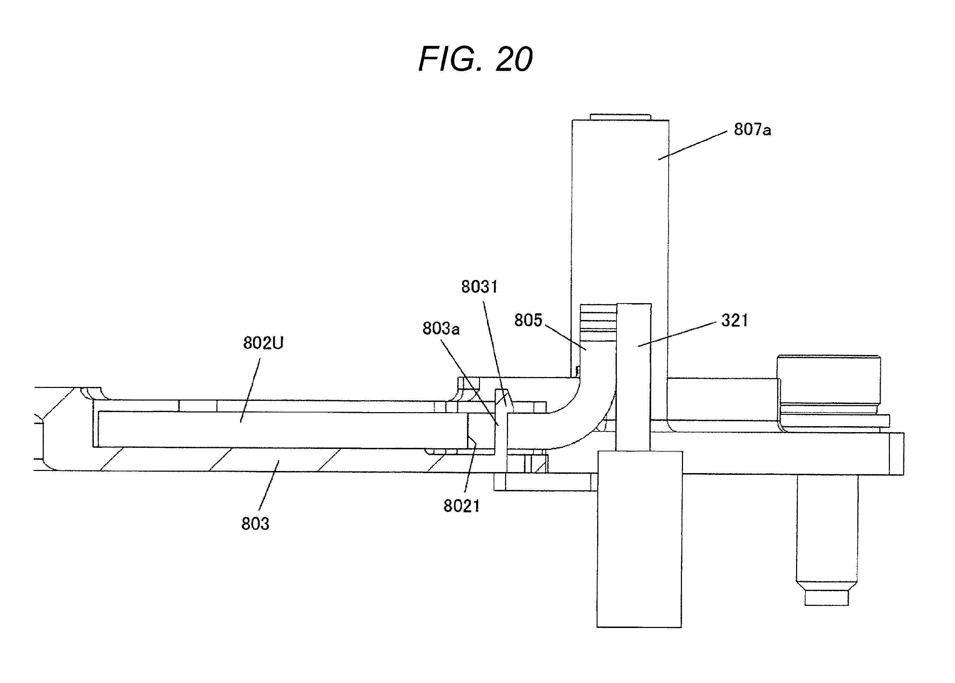

FIG. 20 is a diagram illustrating a connection portion of the AC busbar 802U and the AC terminal 321 of the power module 300U. The same connection structure is employed also for the AC busbars 802V and 802W of the other phases and the AC terminals of the power modules 300V and 300W. Each one of the AC busbars 802U to 802W maintained in the holding member 803 has a connection portion 805 that is formed to vertically rise in an end portion located on a side opposite to the output end. These connection portions 805 are welded to be connected to the AC terminals 321 of the power modules 300U to 300W illustrated in FIG. 10.

In this embodiment, a hook 803a that regulates the vertical movement of the AC busbars 802U to 802W is disposed in the holding member 803 such that the AC busbars 802U to 802W on the holding member 803 are not vertically deviated in the position at the time of the welding process. As a result, the precision of the positioning between the AC terminal 321 and the connection portion 805 is improved, and the tip ends of the AC terminal 321 and the connection portion 805 can coincide with each other. By allowing the heights of the welding portions to coincide with each other, appropriate weld penetration can be acquired, whereby the intensity and the reliability of the welding portion can be improved. In addition, in this embodiment, although the connection portion 805 is configured to be connected through welding, the connection portion may be connected through screw stop or the like.

As illustrated in FIG. 20, the hook 803a is formed to protrude from the bottom face of the holding member 803 to the upper side, and the claw-shaped portion 8031 is formed in the tip end portion. In the AC busbar 802U, the through hole 8021 is formed near the connection portion 805, and the hook 803a is inserted into and passed through this through hole 8021. Then, the claw-shaped portion 8031 of the tip end portion of the hook 803a is engaged with the upper face of the AC busbar 802U. As a result, the vertical movement of the AC busbar 802U is regulated, and a deviation of the connection portion 805 in the upward direction illustrated in the figure with respect to the AC terminal 321 is prevented.

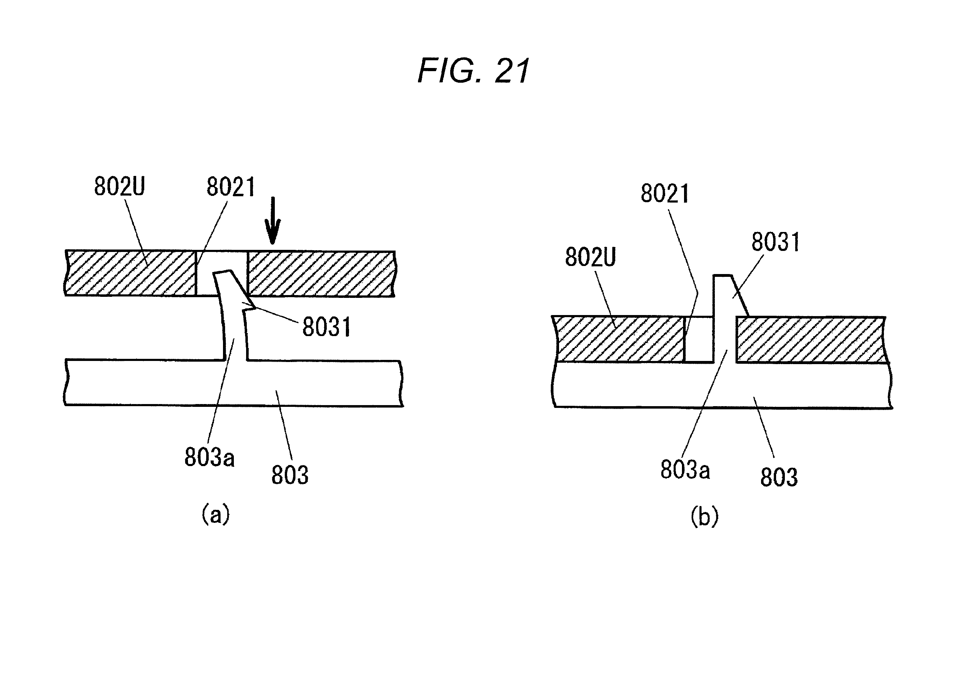

FIG. 21 is a diagram illustrating the operation of locking the AC busbar 802U by using the hook 803a. As illustrated in FIG. 21(a), when the AC busbar 802U is moved in the direction of the holding member 803, the edge of the through hole 8021 of the AC busbar 802U is brought into contact with the inclined face of the claw-shaped portion 8031 of the hook 803a, and the hook 803a is elastically deformed to incline. Then, when the AC busbar 802U is mounted in the holding member 803 as illustrated in FIG. 21(b) by further pressing down the AC busbar 802U, the hook 803a that has inclined is returned to the original state, and the claw-shaped portion 8031 locks the upper face of the AC busbar 802U.

In this way, by mounting the AC busbar 802U in the holding member 803, the AC busbar 802 can be fixed to the holding member 803 through one touch at the time of the assembly process. Then, since the hook 803a and the AC busbar 802U are locked with each other, the bending or floating of the AC busbar 802U can be prevented, whereby the operability is improved.

In addition, near the output ends of the AC busbars 802U to 802W, as illustrated in FIG. 18, the current sensor module 180 is disposed. Accordingly, a convex portion 803b is formed in the holding member 803 so as not to be deviated in the position from the sensing device of the current sensor module 180 when the AC connector 187 is attached to or detached from the output ends of the AC busbars 802U to 802W.

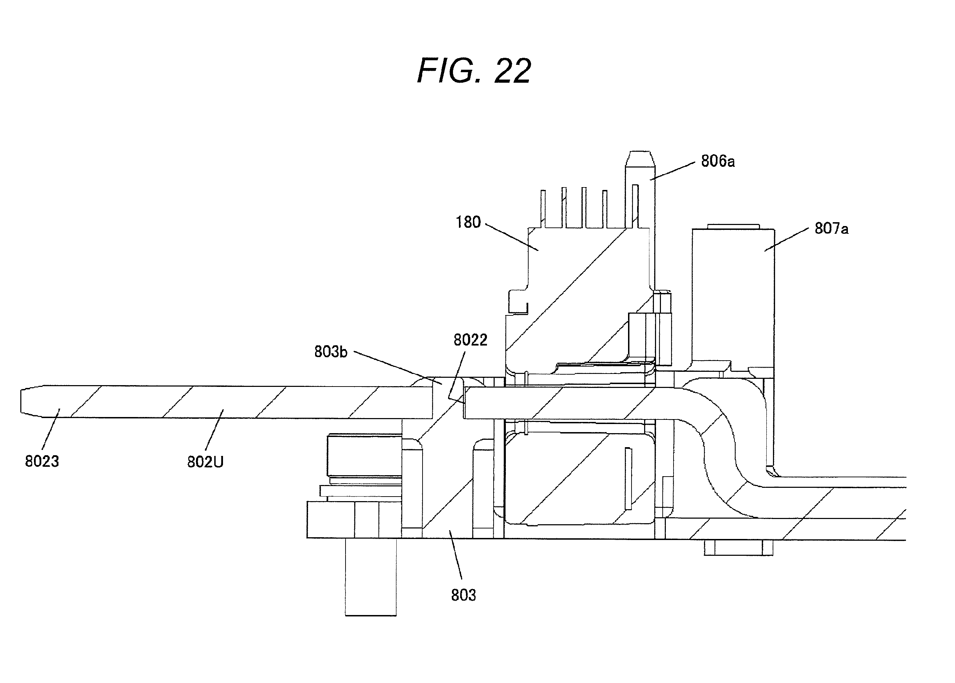

FIG. 22 is a cross-sectional view of an area near the output end 8023 of the AC busbar 802U. While the AC busbar 802U is disposed so as to pass through the current sensor module 180, a through hole 8022 is formed between the detection position of the current sensor module 180 and the output end. On the upper face side of the holding member 803, the convex portion 803b that upwardly protrudes is formed, and the convex portion 803b is inserted into the through hole 8022 of the AC busbar 802U. As a result, the movement of the AC busbar 802U in the horizontal direction is regulated.

Apparently, while the through hole 8022 and the convex portion 803b may be arranged on the connection portion 805 side of the detection position of the current sensor module 180, by arranging them at positions near the output end as illustrated in FIG. 13, a distance up to a portion formed according to the hook 803a becomes long, whereby there is an advantage that the effect of the regulating of the positional deviation is further improved.

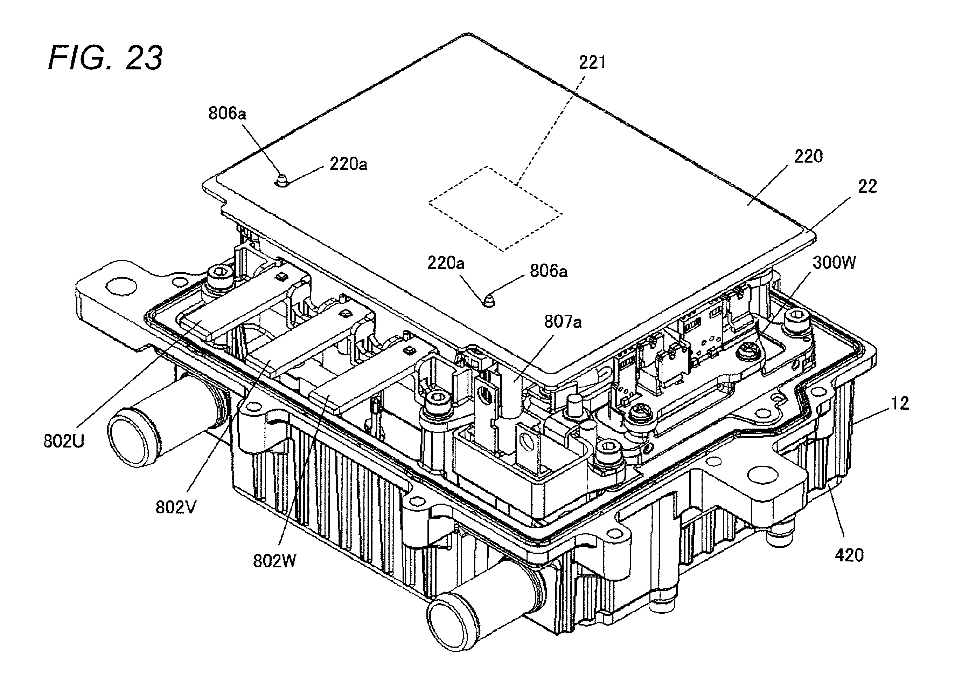

FIG. 23 is a diagram illustrating an insulating sheet 220 placed on the driver circuit board 22. As illustrated in FIG. 6, when the busbar assembly 800 is fixed to the cooling block 12, and the driver circuit board 22 is fixed on the post 807a, the chassis 10 that is the upper casing is fixed to the cooling block 12 configuring the lower casing through bolt fastening or the like. As a result, the busbar assembly 800 in which the AC busbars 802U to 802W and the current sensor module 180 are maintained in the holding member 803 and the driver circuit board 22 that is fixed to the post 807a of the busbar assembly 800 are housed in the housing space formed by the chassis 10. At this time, the partition wall 10c of the chassis 10 is arranged with a small gap arranged right above the driver circuit board 22 being vacant.

Thus, in this embodiment, in order to improve the insulation between the driver circuit board 22 and the partition wall 10c, the insulating sheet 220 as illustrated in FIG. 23 is disposed. The insulating sheet 220 is a sheet-shaped member that is formed from an insulating material such as a PET sheet, and two positioning through holes 220a which the above-described positioning pin 806a is inserted into and passed through are formed. In addition, a cooling sheet 221 is firmly fixed to the face of the insulating sheet 220 that is disposed on the driver circuit board 22 side.

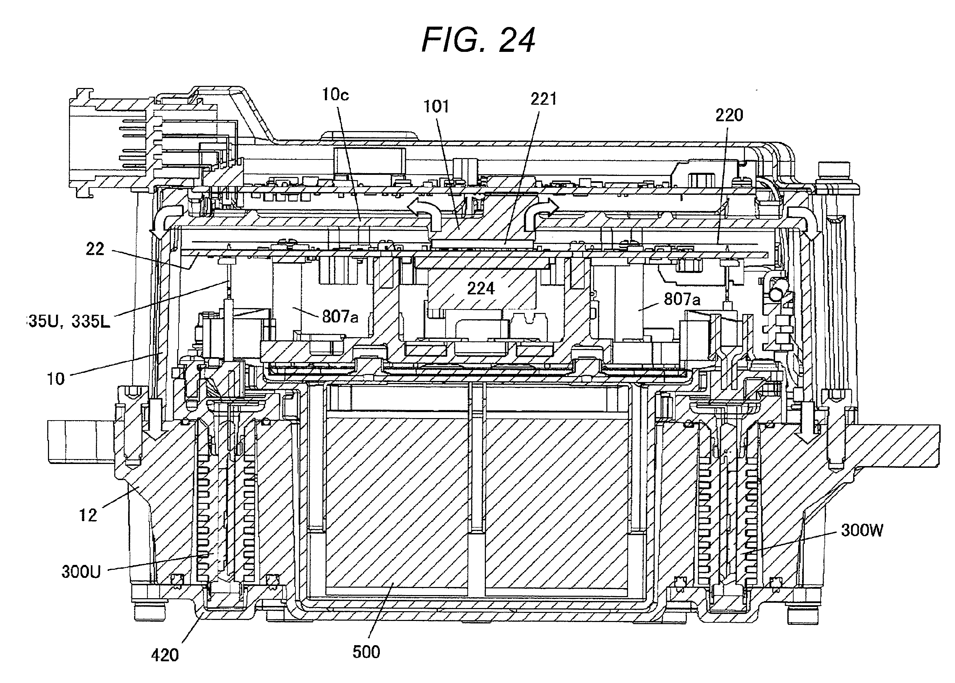

FIG. 24 is a cross-sectional view of the power inverter 200 and is a cross-section of the portion of the cooling sheet 221. The driver circuit board 22 fixed on the post 807a is fixed with the face on which circuit components are mounted is disposed toward the holding member 803 side. In addition, the signal terminals 335U and 335L of the power module 300 are connected so as to pass through the driver circuit board 22, and the tip ends thereof protrude to the upper side of the driver circuit board 22 that is illustrated in the figure.

In the example illustrated in FIG. 24, a heat generating component 224 such as a transformer is arranged near the center of the driver circuit board 22, and the cooling sheet 221 fixed to the insulating sheet 220 is fixed to a position facing the area in which the heat generating component is arranged. When the cooling sheet 221 is placed on the driver circuit board 22 such that the positioning pin 806a is inserted into and passed through the through hole 220a of the cooling sheet 221, the cooling sheet 221 disposed on the insulating sheet 220 is arranged in the heating component mounting area of the driver circuit board 22. Accordingly, the operability relating to the assembly of the insulating sheet 220 is excellent.

As illustrated in FIG. 24, on the lower face of the partition wall 10c, a convex portion 101 having a flat lower end is formed so as to face the area in which the cooling sheet 221 is disposed. In this embodiment, when the chassis 10 is fixed on the cooling block 12, the cooling sheet 221 is configured to be interposed between the convex portion 101 and the heat generating component mounting area of the driver circuit board 22. The heat of the driver circuit board 22 is transferred to the partition wall 10c through the cooling sheet 221, is transferred to the cooling block 12 in a path as denoted by an arrow, and is cooled by the cooling water flowing inside the cooling block 12. Accordingly, the driver circuit board 22 can be more effectively cooled.

As the cooling sheet 221, a silicone cooling sheet having an electrical insulating property and superior thermal conductivity or the like is used. In the above-described example, although the cooling sheet 221 is attached to the insulating sheet 220 so as to form one body, and the insulating sheet 220 is placed on the driver circuit board 22, instead of attaching the cooling sheet 221, a center area of the insulating sheet 220 may be formed to be thick so as to serve as a cooling portion. However, in the case of the configuration in which the cooling sheet 221 is attached, since the insulating property is secured by the insulating sheet 220, a material having further superior thermal conductivity may be used for the cooling sheet 221. In addition, in the case of a configuration in which cooling through a contact with the partition wall 10c is not necessary, the cooling sheet 221 may be omitted.

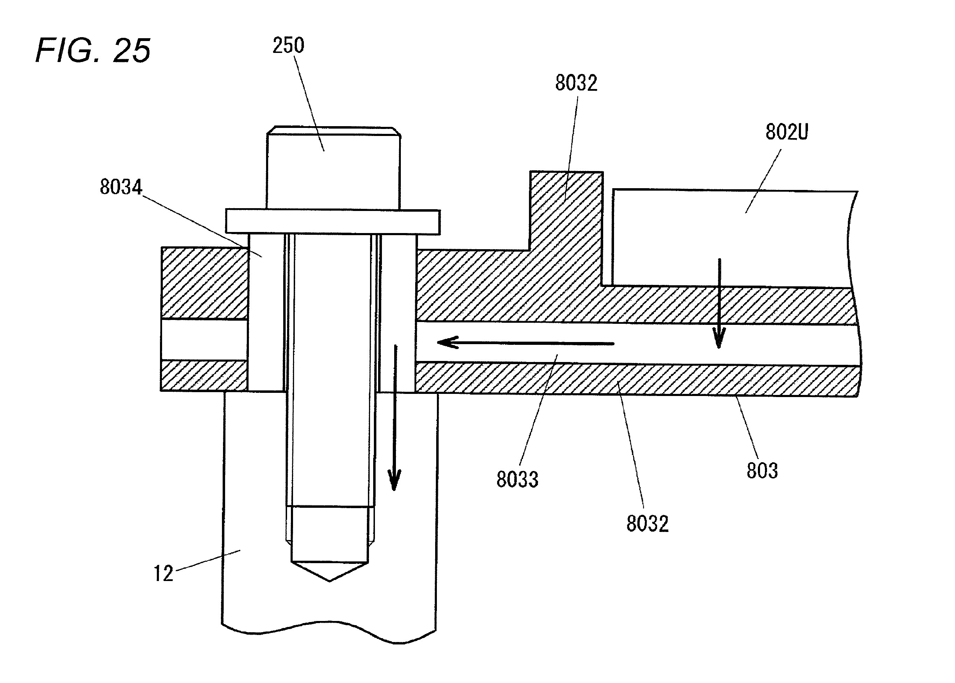

FIG. 25 schematically illustrates the cross-section of a portion in which the holding member 803 is fixed to the cooling block 12. The holding member 803 is acquired by coating the surface of a metal base portion 8033 with a resin portion 8032. In the example illustrated in FIG. 25, while the metal base portion 8033 is exposed on the side face of the holding member 803, the metal base portion 8033 may be exposed in a range which does not influence an insulting property as above, or the entire surface of the metal base portion 8033 may be covered with the resin portion 8032. The AC busbar 802U is maintained on the resin portion 8032.

In a bolt fixing portion of the holding member 803, an insert 8034 is pressingly inserted to pass through the holding member 803. By fastening the portion of the insert 8034 to the cooling block 12 using the bolt 250, the holding member 803 is fixed to the cooling block 12. The insert 8034 pressingly inserted into the holding member 803 is brought into contact with the metal base portion 8033. Accordingly, the Joule heat generated in accordance with the flow of the current in the AC busbar 802U, as illustrated by arrows, is transferred to the AC busbar 802U → the metal base portion 8033 → the insert 8034 → the cooling block 12 and is cooled by the cooling water that flows inside the cooling block 12.

In this way, by arranging the metal base portion 8033 in the holding member 803, compared to a case where the entirety of the holding member 803 is formed using a resin, the cooling performance of the AC busbar can be improved. As a result, an increase in the temperature of the holding member 803 can be suppressed, and the life and the reliability of an electronic component (for example, the current sensor device) maintained in the holding member 803 can be lengthened and improved. The insert 8034 may be integrated with the metal base portion 8033 by being pressingly inserted thereinto as described above or may be integrated therewith through welding. In other words, the insert 8034 forms a part of the metal base portion 8033.

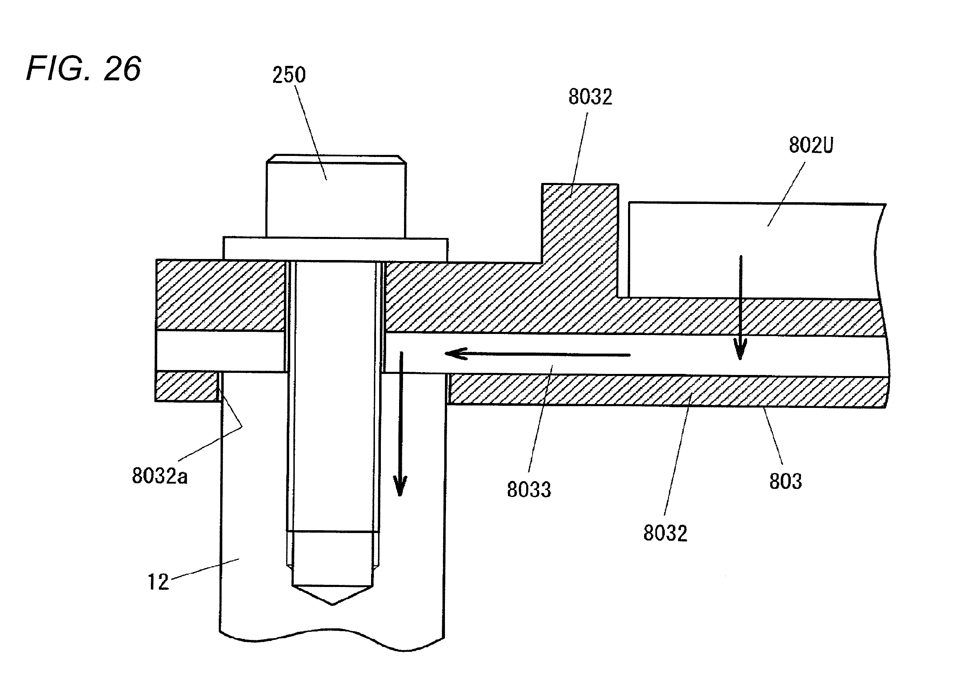

In addition, in the example illustrated in FIG. 25, while the heat of the metal base portion 8033 is efficiently transferred to the cooling block 12 by using the insert 8034 made of metal, the insert 8034 may be omitted by employing the structure as illustrated in FIG. 26. In the configuration illustrated in FIG. 26, a counterbore 8032a is formed on the rear face side of the holding member 803, a part of the resin portion 8032 is removed, and a part of the metal base portion 8033 is exposed. By employing such a configuration, the metal base portion 8033 and the cooling block 12 are directly brought into contact with each other, and the cooling performance for the holding member 803 can be further improved.

The embodiments described above may be used in an independent manner or in a combined manner. The reason for this is that the effects of the embodiments can be independently acquired or can be acquired in a multiplied manner. In addition, the present invention is not limited to such contents, and the other embodiments considered within the scope of the technical idea of the present invention belong to the scope of the present invention.

The entire contents of the following application on which claim of the priority is based are incorporated herein by reference.

Japanese Patent Application No. 2011-161145 (filed on July 22, 2011)

## Claims

1. A power inverter comprising:
a plurality of power modules each including a power semiconductor device that converts a DC current into an AC current;
a first casing in which the plurality of power modules are housed, and a cooling path in which a coolant used for cooling the plurality of power modules flows is formed;
a plurality of AC busbars that are respectively connected to AC terminals of the plurality of power modules and are used for outputting AC currents;
a holding member, in which a positioning pin protruding to an upper side in a direction opposite to the first casing is formed, that maintains the plurality of AC busbars and is fixed to the first casing;
a current sensor module that includes a plurality of current sensors detecting the AC currents of the plurality of AC busbars, a frame body, in which a module positioning through hole which the positioning pin is inserted into and is passed through is formed, that integrally maintains the plurality of current sensors and is arranged on the holding member, and a lead terminal being disposed to protrude from the frame body to the upper side and outputting detection signals of the plurality of current sensors; and
a driver circuit board, in which a through hole used for the lead terminal which the lead terminal is inserted into and passed through and a board positioning through hole which the positioning pin is inserted into and passed through are formed, that is arranged on the upper side of the frame body arranged on the holding member and has a circuit, which drives the power semiconductor device based on the detection signals, being mounted,
wherein a tip end of the positioning pin protrudes to the upper side of a tip end of the lead terminal that protrudes from the frame body arranged in the holding member.

2. The power inverter according to claim 1, further comprising a locking portion that is disposed to protrude on the holding member and regulates displacement of the AC busbars in a protruding direction by being passed through a first through hole of each one of the AC busbars and locking a face of the AC busbar that is disposed on a side opposite to a face facing the holding member,
wherein each of the AC busbars is equipped with a connection portion that is formed in an end portion disposed on a side opposite to an output end and is connected to the AC terminal of the power module and the first through hole that is arranged near the connection portion.

3. The power inverter according to claim 2,
wherein the output end side of the plurality of the AC busbars is arranged so as to be passed through the frame body of the current sensor module,
wherein each one of the AC busbars is equipped with a second through hole that is formed on a side closer to the output end than the frame body, and
wherein the holding member is equipped with a protrusion that is inserted into the second through hole.

4. The power inverter according to any one of claims 1 to 3, further comprising:
a capacitor module that is housed in the first casing and is connected in parallel to the plurality of power modules; and
a harness that connects the capacitor module and the driver circuit board to each other,
wherein a guide member that guides the harness to detour around the AC busbars is formed in the holding member.

5. The power inverter according to any one of claims 1 to 4, further comprising:
a top plate portion that is arranged to face a face of the driver circuit board that is disposed on a side opposite to the holding member side; and
a side face portion that is disposed to surround lateral sides of the driver circuit board and is connected to the first casing;
a second casing that houses at least the driver circuit board; and
an insulating sheet, in which a sheet positioning hole which the positioning pin is inserted into and passed through is formed, that is arranged in a gap formed between the top plate portion and the driver circuit board.

6. The power inverter according to claim 5,
wherein a convex portion that protrudes in the direction of the driver circuit board and is brought into contact with the insulating sheet is formed in an area facing a heat-generating component mounting area of the driver circuit board in the top plate portion, and
wherein the insulating sheet is interposed between the heat-generating component mounting area of the driver circuit board and the convex portion.

7. The power inverter according to claim 6, wherein a cooling sheet that is firmly fixed to a face of the insulating sheet that faces the heat-generating component mounting area and has thermal conductivity higher than the insulating sheet is interposed between the insulating sheet and the driver circuit board.

8. The power inverter according to any one of claims 1 to 7, wherein the holding member is equipped with a plurality of posts that protrude from the holding member in the direction of the driver circuit board and support the driver circuit board.

9. The power inverter according to any one of claims 1 to 8, wherein the holding member fixed to the first casing is equipped with a metal base portion that is brought into contact with the first casing and a resin portion that coats a part of the surface of the metal base portion and maintains the plurality of AC busbars.
